(19) **Europäisches Patentamt / European Patent Office / Office européen des brevets**

(11) **EP 2 538 759 A1**

(12) **EUROPEAN PATENT APPLICATION**
published in accordance with Art. 153(4) EPC

(43) Date of publication:
26.12.2012 Bulletin 2012/52

(51) Int Cl.:
*H05G 2/00* (2006.01)

(21) Application number: 11744564.3

(22) Date of filing: 09.02.2011

(86) International application number:
PCT/JP2011/052767

(87) International publication number:
WO 2011/102277 (25.08.2011 Gazette 2011/34)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 27.01.2011 JP 2011015691
29.11.2010 JP 2010265789
19.02.2010 JP 2010034889

(71) Applicant: Gigaphoton Inc.
Tochigi 323-8558 (JP)

(72) Inventors:
• HORI Tsukasa
Hiratsuka-shi
Kanagawa 254-0014 (JP)

• KAKIZAKI Kouji
Hiratsuka-shi
Kanagawa 254-0014 (JP)
• YANAGIDA Tatsuya
Hiratsuka-shi
Kanagawa 254-0014 (JP)
• WAKABAYASHI Osamu
Hiratsuka-shi
Kanagawa 254-0014 (JP)

(74) Representative: Hards, Andrew
Global IP Europe
Patentanwaltskanzlei
Pfarrstrasse 14
80538 München (DE)

(54) **EXTREME-ULTRAVIOLET LIGHT SOURCE DEVICE AND METHOD FOR GENERATING EXTREME-ULTRAVIOLET LIGHT**

(57) An extreme ultraviolet light generating apparatus may include a laser beam generating system, a laser control system to control at least one of a beam intensity and an output timing of at least one laser beam output from the laser beam generating system, a chamber provided with at least one inlet to guide the at least one laser beam output from the laser beam generating system into the chamber, and a target supplying part provided in the chamber to supply a target material to a predetermined region inside the chamber. Hence, the CE of the extreme ultraviolet light generating apparatus may be improved.

FIG. 1

EP 2 538 759 A1

**Description**

TECHNICAL FIELD

The present disclosure relates to an extreme ultraviolet (EUV) light source apparatus for generating extreme ultraviolet light for use in exposing a semiconductor wafer or the like, and to a method of generating the extreme ultraviolet light.

BACKGROUND ART

In recent years, fine pattern photolithography has progressed rapidly with increased integration density of semiconductor processes, and the requirement of the next generation microfabrication may be on the order of 60 nm to 45 nm and even 32 nm or lower. For this reason, in order to satisfy the microfabrication requirement of 32 nm or lower, for example, there are expectations to develop an exposure apparatus that combines an EUV light source to generate EUV light at a wavelength on the order of 13 nm and a reduced projection reflective optics.

There are three kinds of EUV light source apparatuses, including a laser produced plasma (LPP) light source apparatus that uses plasma produced by irradiating a target with a laser beam, a discharge produced plasma (DPP) light source apparatus that uses plasma produced by discharge, and a synchrotron radiation (SR) light source apparatus that uses orbital synchrotron radiation light.

SUMMARY

According to one aspect of the present disclosure, an extreme ultraviolet light source apparatus may include a laser beam generating system, a laser control system to control at least one of a beam intensity and an output timing of at least one laser beam output from the laser beam generating system, a chamber provided with at least one inlet to guide the at least one laser beam output from the laser beam generating system into the chamber, and a target supplying part provided on the chamber to supply a target material to a predetermined region within the chamber.

According to another aspect of the present disclosure, a method of generating extreme ultraviolet light may include supplying a target material into a chamber in a form of a droplet, irradiating the droplet with a prepulse laser beam output from a laser beam generating system, and irradiating the droplet irradiated with the prepulse laser beam with a main pulse laser beam output from the laser beam generating system after a predetermined time elapses from a time when the droplet is irradiated with the prepulse laser beam.

BRIEF DESCRIPTION OF THE DRAWING

FIG. 1 is a schematic diagram illustrating a general configuration of an extreme ultraviolet (EUV) light source apparatus in an embodiment of the present disclosure.

FIG. 2 is a schematic diagram illustrating a state in which a droplet is irradiated with a prepulse laser beam.

FIGS. 3A through 3C are diagrams illustrating a first example of simulation results of a diffused state of a droplet in a case in which a molten tin metal droplet is irradiated with a prepulse laser beam, and FIG. 3D is a photograph of a state taken of a droplet in a case in which the molten tin metal droplet is actually irradiated with the prepulse laser beam.

FIGS. 4A and 4B are diagrams schematically illustrating a second example of the diffused state of the droplet in a case in which the molten tin metal droplet is irradiated with the prepulse laser beam.

FIGS. 5A through 5I are diagrams illustrating simulation results of the diffused state of the droplet in a case in which the molten tin metal droplet having a diameter of 60 $\mu$m is irradiated with the prepulse laser beam.

FIG. 6 is a diagram illustrating a diffusion diameter of a diffused target in a case in which the molten tin metal droplet having the diameter of 60 $\mu$m is irradiated with the prepulse laser beam, and a CE according to an irradiating timing with a main pulse laser beam with respect to the diffused target.

FIGS. 7A through 7I are diagrams illustrating simulation results of a state of the diffused target in a case in which the molten tin metal droplet having a diameter of 10 $\mu$m is irradiated with the prepulse laser beam.

FIG. 8 is a diagram illustrating the diffusion diameter of the diffused target in a case in which the molten tin metal droplet having the diameter of 10 $\mu$m is irradiated with the prepulse laser beam, and the CE according to the irradiating timing with the main pulse laser beam.

FIG. 9 is a schematic diagram of an EUV light source apparatus in a first embodiment.

FIG. 10 is a schematic diagram of an EUV light source apparatus in a second embodiment.

FIG. 11 is a schematic diagram of an EUV light source apparatus in a third embodiment.

FIGS. 12A through 12F are schematic diagrams illustrating a state of a diffused target in a case in which the droplet is irradiated with a first prepulse laser beam and is further irradiated with a second prepulse laser beam.

FIG. 13 is a schematic diagram of an EUV light source apparatus in a fourth embodiment.

FIG. 14 is a schematic diagram illustrating an example of the configuration of a titanium-sapphire laser that generates a prepulse laser beam in an EUV light source apparatus in a fifth embodiment.

FIG. 15 is a schematic diagram illustrating an example of the configuration of a fiber laser that generates a prepulse laser beam in an EUV light source apparatus in a sixth embodiment.

FIGS. 16A and 16B are tables illustrating examples of laser beam irradiating conditions in the EUV light source apparatuses mentioned above.

FIG. 17 is a schematic diagram illustrating an EUV light source apparatus in a seventh embodiment.

FIG. 18A is a schematic diagram illustrating a state in which the droplet is irradiated with a linearly polarized prepulse laser beam, and FIG. 18B is a diagram illustrating a simulation result of the diffused state of the droplet.

FIG. 19A is a schematic diagram illustrating a state in which the droplet is irradiated with the linearly polarized prepulse laser beam, and FIG. 19B is a diagram illustrating a simulation result of the diffused state of the droplet.

FIG. 20 is a graph illustrating an absorptance of incident P-polarized and S-polarized laser beams with respect to the molten tin metal droplet.

FIGS. 21A through 21F are schematic diagrams illustrating a state in which the droplet is irradiated with a circularly polarized prepulse laser beam and the diffused droplet is irradiated with the main pulse laser beam in the seventh embodiment.

FIGS. 22A through 22F are schematic diagrams illustrating a state in which the droplet is irradiated with a spatially random linearly polarized prepulse laser beam and the diffused droplet is irradiated with the main pulse laser beam in the seventh embodiment.

FIGS. 23A through 23F are schematic diagrams illustrating a state in which the droplet is irradiated with a radially polarized prepulse laser beam and the diffused droplet is irradiated with the main pulse laser beam in the seventh embodiment.

FIGS. 24A through 24F are schematic diagrams illustrating a state in which the droplet is irradiated with an azimuthally polarized prepulse laser beam and the diffused droplet is irradiated with the main pulse laser beam in the seventh embodiment.

FIGS. 25A and 25B are diagrams for discussing an example of a degree of linear polarization measuring method to measure a rate of linear polarization.

FIG. 26 is a diagram illustrating a first example of a polarizer in the seventh embodiment.

FIGS. 27A through 27C are diagrams illustrating a second example of the polarizer in the seventh embodiment.

FIGS. 28A and 28B are diagrams illustrating a third example of the polarizer in the seventh embodiment.

FIG. 29 is a diagram illustrating a fourth example of the polarizer in the seventh embodiment.

FIG. 30 is a schematic diagram of an EUV light source apparatus in an eighth embodiment.

FIGS. 31A through 31C are schematic diagrams illustrating an example of the configuration of a laser unit that generates a prepulse laser beam in an EUV light source apparatus in a ninth embodiment.

FIGS. 32A through 32C are schematic diagrams illustrating an example of the configuration of the laser unit that generates a prepulse laser beam in an EUV light source apparatus in a modification of the ninth embodiment.

FIGS. 33A and 33B are diagrams illustrating an example of the polarizer in the ninth embodiment.

FIG. 34 is a diagram illustrating results of an experiment to generate a diffused target in the EUV light source apparatus in the eight embodiment.

## EMBODIMENTS

A detailed description will be given of embodiments of the present disclosure with reference to the drawings. The embodiments described hereunder show examples of the present disclosure, and do not limit the scope of the present disclosure. In addition, configurations described in the embodiments are not necessarily essential configurations of the present disclosure. Those constituent elements that are the same are designated by the same reference characters, and a duplicate description thereof will be omitted.

<1. General Configuration>

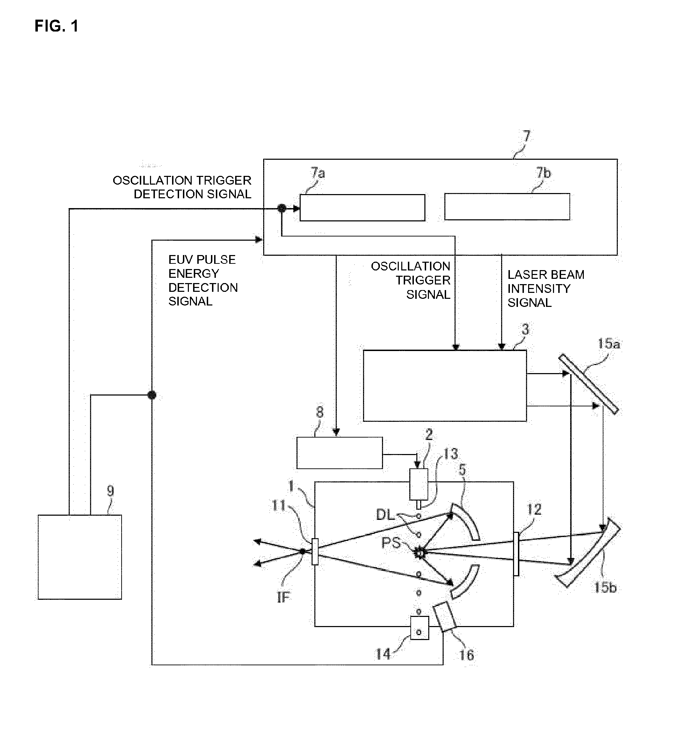

FIG. 1 is a schematic diagram illustrating a general configuration of an extreme ultraviolet (EUV) light source apparatus in an embodiment of the present disclosure. The EUV light source apparatus in this embodiment employs the laser produced plasma (LPP) system that generates EUV light by irradiating a target material with a laser beam in order to excite the target material. As illustrated in FIG. 1, this EUV light source apparatus may include a chamber 1, a target supplying part 2, a driver laser 3, an EUV collector mirror 5, and an EUV light source controller 7.

The chamber 1 is preferably a vacuum chamber, and the EUV light is generated inside the chamber 1. An exposure apparatus connecting port 11 and a window 12 may be provided on the chamber 1. The EUV light generated inside the chamber 1 may be output via the exposure apparatus connecting port 11 to an external processing apparatus, such as an exposure apparatus (reduced projection reflective optics) or the like. A laser beam output from the driver laser 3 may enter the chamber 1 via the window 12.

The target supplying part 2 supplies a target material, such as tin (Sn) and lithium (Li), that is used to generate the EUV light into the chamber 1 at a timing instructed by a droplet controller 8. In the chamber 1, the target material inside the target supplying part 2 is output through a target nozzle 13 in a form of droplets DL. The droplet DL may have a diameter of 10 $\mu$m or greater and 100 $\mu$m or less. Among the plurality of droplets DL supplied into the chamber 1, those droplets DL that are not irradiated with the laser beam and have become unnecessary may be collected in a target collection cylinder 14.

The driver laser 3 generates the laser beam that is used to excite the target material. The driver laser 3 may be a master oscillator power amplifier type laser apparatus. For example, the driver laser 3 may output a pulse laser beam having a pulse duration on the order of several ns to several tens of ns and a repetition rate on the order of 10 kHz to 100 kHz. In this embodiment, the driver laser 3 generates a prepulse laser beam and a main pulse laser beam. For example, the driver laser 3 uses a combination of a yttrium aluminum garnet (YAG) laser apparatus that generates the prepulse laser beam and a carbon dioxide ($CO_2$) laser apparatus that generates the main pulse laser beam; however, other laser apparatuses may be used.

Each of the prepulse laser beam and the main pulse laser beam output from the driver laser 3 may be focused on the droplet DL inside the chamber 1 via a laser beam focusing optical system and the window 12, the laser beam focusing optical system including a high reflection mirror 15a, an off-axis paraboloidal mirror 15b, and the like.

When the droplet DL is irradiated with the prepulse laser beam, the droplet DL diffuses in a form of microparticles. In this application, the target material in a state in which the droplet DL is pulverized and diffused in the form of microparticles is referred to as a diffused target. The main pulse laser beam strike the diffused target that is formed by the diffusion of the droplet DL. When the target material is excited and turned into plasma by energy of the main pulse laser beam, light at various wavelengths including the EUV light are emitted from the plasma.

The EUV collector mirror 5 is a collecting optical system to collect light at a predetermined wavelength (for example, EUV light at a wavelength around 13.5 nm) among rays at various wavelengths emitted from the plasma. For example, the EUV collector mirror 5 may have a concave spheroidal reflection surface that is formed by a molybdenum (Mo)/silicon (Si) multi-layer to selectively reflect the EUV light at the wavelength around 13.5 nm. The EUV collector mirror 5 may be arranged so that a first focus of the spheroidal surface lies in a plasma generation site PS. The EUV light reflected by the EUV collector mirror 5 may be focused at a second focus of the spheroidal surface, that is, an intermediate focus (IF), and output to an external exposure apparatus or the like.

The EUV light source controller 7 may supply an oscillation trigger signal and a laser beam intensity setting signal to the driver laser 3. Hence, the EUV light source controller 7 may control a beam intensity and a generation timing of the prepulse laser beam so that the droplet inside the chamber 1 transforms into a desired diffused target. In addition, the EUV light source controller 7 may control a beam intensity and a generation timing of the main pulse laser beam so that plasma in a desired state is generated from the diffused target by the irradiation with the main pulse laser beam.

The oscillation trigger signal may be output based on an oscillation trigger detection signal from an exposure apparatus controller 9, in order to control the generation timing of the laser beam output from the driver laser 3. The laser beam intensity setting signal may be output based on the oscillation trigger detection signal from the exposure apparatus controller 9 and an EUV pulse energy detection signal from an EUV light detector 16 inside the chamber 1 or from the exposure apparatus controller 9. The laser beam intensity setting signal may be output to the driver laser 3 in order to control the beam intensity of the laser beam. In addition, the EUV light source controller 7 may include a trigger counter 7a and a timer 7b, in order to count the number of oscillation trigger detection signals per predetermined time. The laser beam intensity setting signal may be output based on the EUV pulse energy detection signal and the counted number of oscillation trigger detection signals.

<2. Diffusion of Droplets>

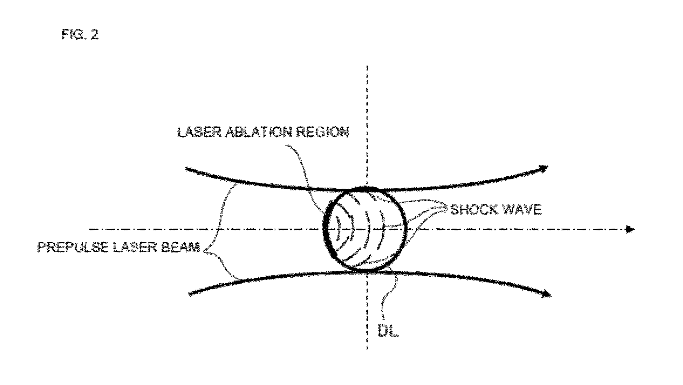

A description will be given of the diffusion of the droplets by being irradiating with the prepulse laser beam. FIG. 2 is a schematic diagram illustrating a state in which the droplet is irradiated with the prepulse laser beam. FIG. 2 illustrates the droplet viewed in a direction perpendicular to a beam axis (Z-axis) of the prepulse laser beam.

As illustrated in FIG. 2, when the prepulse laser beam is focused on the droplet DL inside the chamber, laser ablation occurs near a surface of the droplet DL irradiated with the prepulse laser beam. As a result, a shock wave is generated from the surface of the droplet DL irradiated with the prepulse laser beam toward the inside of the droplet DL. This shock wave propagates throughout the entire droplet DL. The droplet DL will not be destroyed when the beam intensity of the prepulse laser beam is low; however, the droplet DL is destroyed, pulverized, and diffused by this shock wave when the beam intensity of the prepulse laser beam is at a first predetermined value (for example, $1 \times 10^9$ W/cm$^2$) or higher.

<2-1. Disk-shaped or Dish-shaped Diffusion>

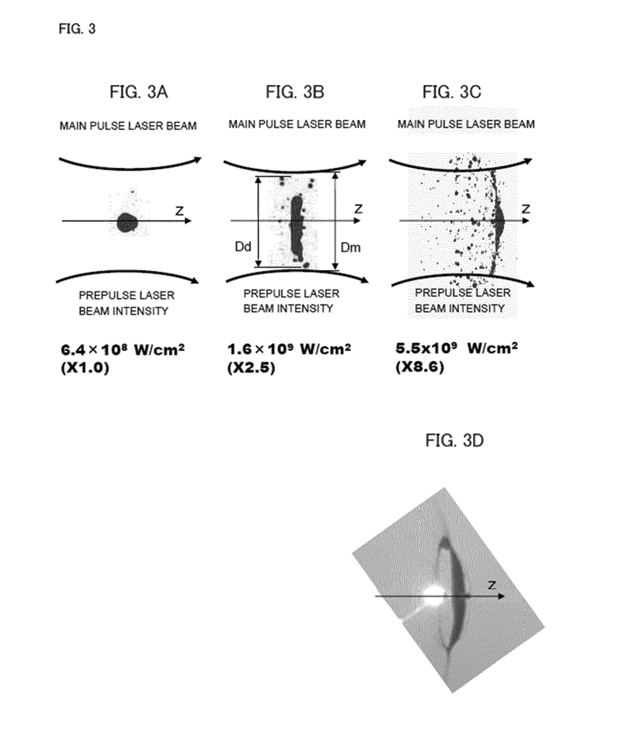

FIGS. 3A through 3C are diagrams illustrating a first example of simulation results of a diffused state of the droplet in a case in which a molten tin metal droplet is irradiated with the prepulse laser beam. FIG. 3D is a photograph of a state taken of a droplet in a case in which the molten tin metal droplet is actually irradiated with the prepulse laser beam under the same conditions as the simulation results illustrated in FIG. 3C. Each of FIGS. 3A through 3D illustrates the droplet viewed in a direction perpendicular to the beam axis of the prepulse laser beam. FIGS. 3A through 3C further illustrate a spot size of the main pulse laser beam and the beam intensity of the prepulse laser beam striking the droplet DL. In addition, FIG. 3B illustrates a diffusion diameter Dd of the diffused target, and an irradiating spot size Dm of the main pulse laser beam.

As illustrated in FIG. 3A, in a case in which the beam intensity of the prepulse laser beam is $6.4 \times 10^8$ W/cm$^2$, virtually no diffusion of the droplet occurs. On the other hand, as illustrated in FIG. 3B, in a case in which the beam intensity of the prepulse laser beam is $1.6 \times 10^9$ W/cm$^2$ (2.5 times the beam intensity of the simulation in FIG. 3A), the droplet is destroyed. The destroyed droplet is pulverized into a large number of microparticles to form a diffused target. These microparticles diffuse in a disk shape as viewed in the Z-axis direction. Further, as illustrated in FIG. 3C, in a case in which the beam intensity of the prepulse laser beam is $5.5 \times 10^9$ W/cm$^2$ (8.6 times the beam intensity of the simulation in FIG. 3A), the microparticles of the destroyed droplet diffuse in a dish shape. As illustrated in FIGS. 3C and 3D, the actual diffused state of the microparticles approximately matched the simulation results.

In the case illustrated in FIG. 3A, because a large portion of the energy of the main pulse laser beam will not be absorbed by the droplet even when the droplet is irradiated with the main pulse laser beam, there is a possibility that a CE will not become high. In other words, an irradiating spot size of the main pulse laser beam is extremely large with respect to a size of the target material irradiated with the prepulse laser beam. For this reason, a large portion of the main pulse laser beam passes without being utilized for plasma generation. On the other hand, in the cases illustrated in FIGS. 3B and 3C, the droplet diffuses within the irradiating spot of the main pulse laser beam, and a large portion of the main pulse laser beam may be utilized for plasma generation. Furthermore, a total surface area of the diffused target becomes larger compared to that in the droplet state (one spherical droplet). As indicated hereunder, when one spherical droplet is destroyed into $n^3$ drops, the radius per drop becomes $(1/n)$ times that of the spherical droplet, and the total of the surface areas of the drops becomes n times the total surface area of one spherical droplet.

When the radius of the droplet before the diffusion is denoted by r, a volume $V_1$ of one droplet may be represented by the following formula (1).

$$V_1 = 4\pi r^3/3 \qquad\qquad \text{---- Formula (1)}$$

On the other hand, a total $V_2$ of volumes of $n^3$ microdrops each having a radius (r/n) after the diffusion may be represented by the following formula (2).

$$V_2 = n^3 \times 4\pi(r/n)^3/3 \qquad \text{---- Formula (2)}$$

The total $V_2$ of the volumes of $n^3$ microdrops each having the radius (r/n) is equal to the volume $V_1$ of one droplet having the radius r ($V_2 = V_1$).

Moreover, a surface area $S_1$ of one droplet having the radius r may be represented by the following formula (3).

$$S_1 = 4\pi r^2 \qquad\qquad \text{---- Formula (3)}$$

On the other hand, a total $S_2$ of surface areas of $n^3$ microdrops each having the radius (r/n) may be represented by the following formula (4).

$$S_2 = n^3 \times 4\pi(r/n)^2 = n \times 4\pi r^2 \quad \text{---- Formula (4)}$$

Accordingly, the total $S_2$ of the surface areas of $n^3$ microdrops each having the radius (r/n) becomes n times the surface area $S_1$ of one droplet having the radius r ($S_2 = n \times S_1$) .

Hence, in the cases illustrated in FIGS. 3B and 3C, the droplet DL diffuses and the total surface area becomes larger. As a result, the energy of the main pulse laser beam is efficiently absorbed by the diffused microparticles. Consequently, a large portion of the diffused microparticles is turned into plasma, and a high-energy EUV light is obtained, and the CE may thus be improved.

In either of the cases illustrated in FIGS. 3B and 3C, the diffused target has a shape shorter in the beam axis direction of the prepulse laser beam than in a direction perpendicular to the beam axis direction of the prepulse laser beam. With respect to this diffused target, the main pulse laser beam preferably strikes the diffused target in substantially the same direction as the prepulse laser beam. Hence, the diffused target may be irradiated with the main pulse laser beam more uniformly, which may allow the target material to efficiently absorb the main pulse laser beam.

In addition, the size of the diffusion diameter Dd of the diffused target is desirably equal to or less than the irradiating spot size Dm of the main pulse laser beam. In this case, the entire diffused target may be irradiated with the main pulse laser beam, and a larger portion of the diffused target may be turned into plasma. As a result, generation of target material debris may be reduced.

Further, the diffusion diameter Dd of the diffused target is desirably equal to or a value close to the irradiating spot size Dm of the main pulse laser beam. In this case, a large portion of the energy of the main pulse laser beam is absorbed by the diffused target, and the CE may thus be improved. FIG. 3B illustrates a case in which the position of a beam waist of the main pulse laser beam is adjusted to approximately coincide with the position of the diffused target; however, the present disclosure is not limited to this embodiment. In other words, the position of the beam waist of the main pulse laser beam and the position of the diffused target does not necessarily have to coincide with each other. In this application, the irradiating spot size Dm is defined as a diameter of a cross section of the beam around the position where the diffused target is irradiated with the laser beam.

The description is given above for the case in which the beam cross section of the main pulse laser beam is circular and the cross section of the diffused target (cross section along a plane perpendicular to a propagating direction of the laser beam) is circular; however, the present disclosure is not limited to such a case. For example, the area of the beam cross section of the main pulse laser beam may exceed a maximum area of the cross section of the diffused target.

<2-2. Torus-shaped Diffusion>

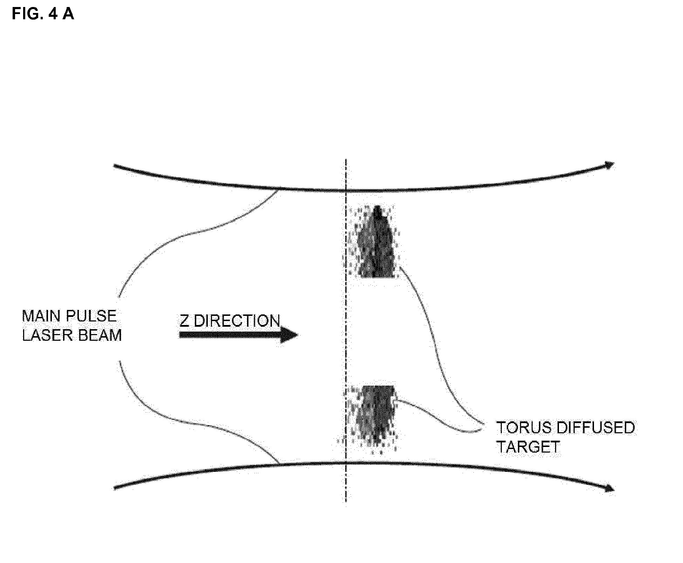

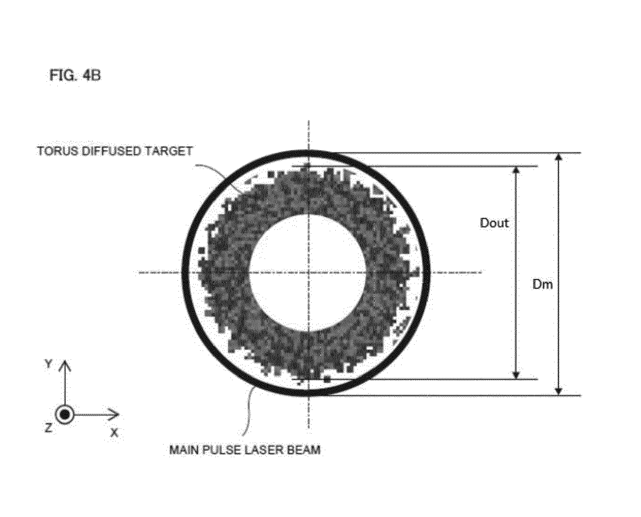

FIGS. 4A and 4B are diagrams schematically illustrating a second example of the diffused state of the droplet in a case in which the molten tin metal droplet is irradiated with the prepulse laser beam. FIG. 4A illustrates the target material viewed in a direction perpendicular to the beam axes of the prepulse laser beam and the main pulse laser beam. FIG. 4B illustrates the target material viewed in the beam axis direction of the main pulse laser beam. FIG. 4B illustrates an outer diameter Dout of the torus diffused target, and the irradiating spot size Dm of the main pulse laser beam.

As described above with reference to FIG. 2, when the prepulse laser beam is focused on the droplet DL, the laser ablation occurs near the surface of the droplet DL. In a case in which the beam intensity of the prepulse laser beam is at a second predetermined value (for example, $6.4 \times 10^9$ W/cm$^2$) or higher, the droplet is destroyed and pulverized, and the torus diffused target as illustrated in FIGS. 4A and 4B may be formed. As illustrated in FIGS. 4A and 4B, the torus diffused target is formed when the droplet is diffused symmetrically with respect to the beam axis of the prepulse laser beam in a torus shape.

Specific conditions for forming the torus diffused target may be as follows, for example. A beam intensity range of the prepulse laser beam is set to $6.4 \times 10^9$ W/cm$^2$ or higher and $3.2 \times 10^{10}$ W/cm$^2$ or lower. The diameter of the droplet is set to 12 $\mu$m or greater and 40 $\mu$m or less.

Next, a description will be given of the irradiation the torus diffused target with the main pulse laser beam. The torus diffused target is formed in 0.5 $\mu$s to 2.0 $\mu$s, for example, after the droplet is irradiated with the prepulse laser beam. Accordingly, the diffused target is preferably irradiated with the main pulse laser beam in the above time period after the droplet is irradiated with the prepulse laser beam.

In addition, as illustrated in FIGS. 4A and 4B, the shape of the torus diffused target is shorter in the beam axis direction of the prepulse laser beam than in the direction perpendicular to the beam axis direction of the prepulse laser beam. With respect to this diffused target, the main pulse laser beam preferably strikes the torus diffused target in substantially the same direction as the prepulse laser beam. Hence, the diffused target may be irradiated with the main pulse laser beam more efficiently, which may allow the target material to efficiently absorb the main pulse laser beam. Accordingly, the CE of the LPP type EUV light source apparatus may be improved. According to experiments conducted by the present inventors, a CE of approximately 3% was confirmed in a case in which the irradiation is made under the conditions described above.

For example, when the torus diffused target is irradiated with the main pulse laser beam having a beam intensity distribution that is a Gaussian distribution, it may be speculated that plasma is emitted in a cylindrical shape from the torus diffused target. In addition, the effect of trapping the plasma diffusing into this cylinder within the cylinder may be expected. Accordingly, it may be speculated that the plasma is generated at a high temperature and a high density to improve the CE . The "torus" shape refers to the shape of a ring torus; however, the diffused target does not necessarily have to be shaped in a ring torus, and may be diffused in a substantially ring shape.

Further, the irradiating spot size Dm of the main pulse laser beam preferably has the following relationship with respect to the outer diameter Dout of the torus diffused target.

$Dm \geq Dout$

By satisfying this relationship, the entire torus diffused target may be irradiated with the main pulse laser beam, in order to turn a larger portion of the diffused target into plasma. As a result, the generation of the target material debris may be reduced.

<2-3. Diffusion of Large Diameter Droplets>

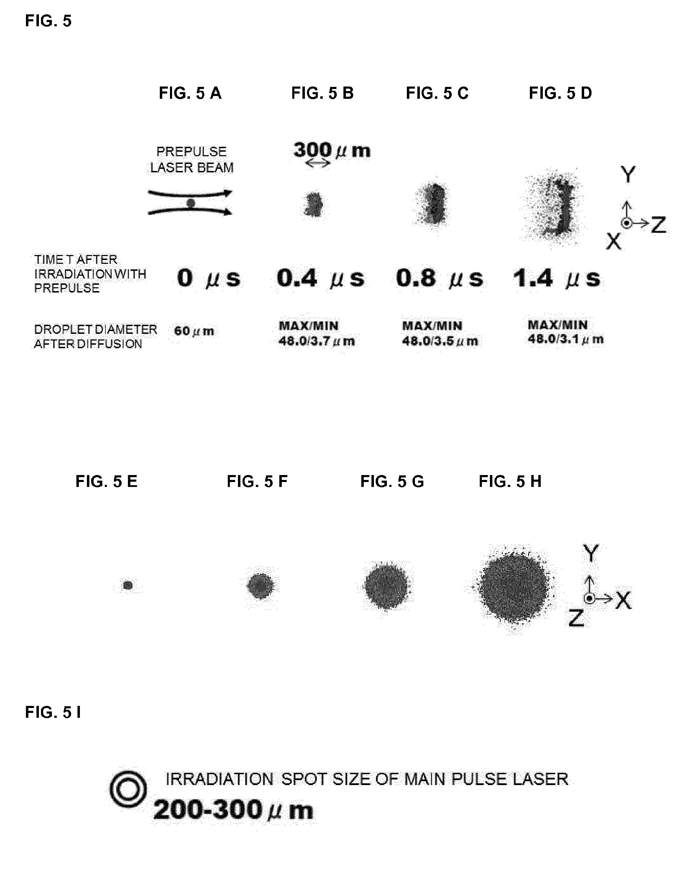

FIGS. 5A through 5H are diagrams illustrating simulation results of the diffused state of the droplet in a case in which the molten tin metal droplet DL having a diameter of 60 $\mu$m is irradiated with the prepulse laser beam. FIGS. 5A through 5D illustrate the state of the droplet and the diffused target as viewed in a direction (X-axis) perpendicular to the beam axis of the prepulse laser beam. FIGS. 5A through 5D illustrate the state of the target material at a time T after the droplet DLis irradiated with the prepulse laser beam when T is 0 $\mu$s, 0.4 $\mu$s, 0.8 $\mu$s, and 1.4 $\mu$s, respectively. FIGS. 5E through 5H illustrate the state of the droplet and the diffused target as viewed in the beam axis direction of the prepulse laser beam. FIGS. 5E through 5H illustrate the state of the target material after the times identical to the times for the cases illustrated in FIGS. 5A through 5D have elapsed, respectively. FIG. 5I illustrates the size of the irradiating spot size of the main pulse laser beam at a position where the diffused target is irradiated with the main pulse laser beam. The illustrations are for a case in which the beam intensity of the prepulse laser beam is $1.5 \times 10^9$ W/cm$^2$.

When the simulation results illustrated in FIGS. 5A through 5H are observed with reference to the irradiating spot size of the main pulse laser beam illustrated in FIG. 5I, the following may be found. Most part of the diffused target may be irradiated with the main pulse laser beam at a timing approximately 0.4 $\mu$s after the irradiation with the prepulse laser beam. Accordingly, it may be conjectured that the generation of the debris may be reduced by taking measures so that the diffused target is irradiated with the main pulse laser beam at such a timing.

The droplet having the diameter of 60 $\mu$m before being irradiated with the prepulse laser beam is diffused into the microparticles by the irradiation with the prepulse laser beam. FIGS. 5A through 5D also illustrate a maximum value and a minimum value of the diameters of the microparticles in the diffused target. At the beam intensity of the prepulse laser beam of this simulation, the maximum value of the diameter of the microparticles in the diffused target is 48.0 $\mu$m. In other words, the pulverization by the prepulse laser beam is insufficient, and it may be speculated that a large portion may not be turned into plasma even by the irradiation with the main pulse laser beam. This suggests the possibility of generating a large amount of debris. In addition, the minimum value of the diameter of the microparticles in the diffused target after the irradiation with the prepulse laser beam is 3.7 $\mu$m after 0.4 $\mu$s, 3.5 $\mu$m after 0.8 $\mu$s, and 3.1 $\mu$m after 1.4 $\mu$s. Hence, it may be speculated that the diameter of the microparticles decreases with the lapse of the time T after the irradiation with the prepulse laser beam and that the number of particles accordingly increases. This suggests the possibility that, in a case in which the molten tin metal droplet having the diameter of 60 $\mu$m is irradiated with the prepulse laser beam and the diffused target is irradiated with the main pulse laser beam in the time T, which is in a range of 0.4 $\mu$s to 1.4 $\mu$s after the irradiation with the prepulse laser beam, the CE may improve as the time T becomes longer.

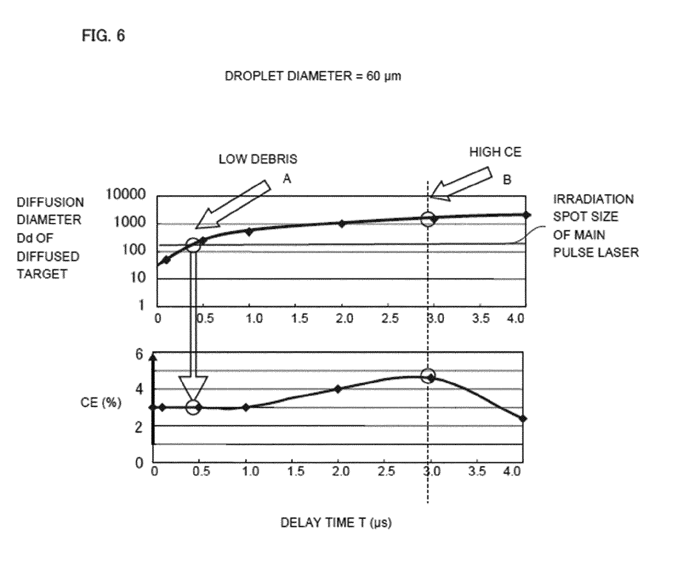

FIG. 6 is a diagram illustrating a change over time in the diffusion diameter Dd of the diffused target in a case in which the molten tin metal droplet having the diameter of 60 $\mu$m is irradiated with the prepulse laser beam, and the CE obtained when the diffused target is irradiated with the main pulse laser beam at a given timing. As illustrated in FIG. 5, the diffusion diameter Dd of the diffused target after approximately 0.4 $\mu$s from the irradiation with the prepulse laser beam substantially coincides with the irradiating spot size of the main pulse laser beam. Accordingly, when the diffused target is irradiated with the main pulse laser beam after approximately 0.4 $\mu$s from the irradiation with the prepulse laser beam, there is a possibility that the generation of the debris may be reduced (arrow A in FIG. 6). On the other hand, FIG. 6 illustrates the possibility that a high CE may be obtained when the diffused target is irradiated with the main pulse laser beam after approximately 3 $\mu$s from the irradiation with the prepulse laser beam (arrow B). From this simulation result, it is found that a delay time from the time when the droplet is irradiated with the prepulse laser beam until the time when the diffused target is irradiated with the main pulse laser beam has a value that is desirable in order to reduce the generation of the debris and a value that is desirable in order to obtain the high CE, and that the two desirable values are different. In other words, in the case in which the molten tin metal droplet having the diameter of 60 $\mu$m is irradiated with the prepulse laser beam and the main pulse laser beam, it may be predicted that simultaneously achieving reduced debris and high CE is not easy. The time T after the irradiation with the prepulse laser beam indicates the same time as the delay time from the time when the droplet is irradiated with the prepulse laser beam until the time when the diffused target is irradiated with the main pulse laser beam.

<2-4. Diffusion of Small Diameter Droplets>

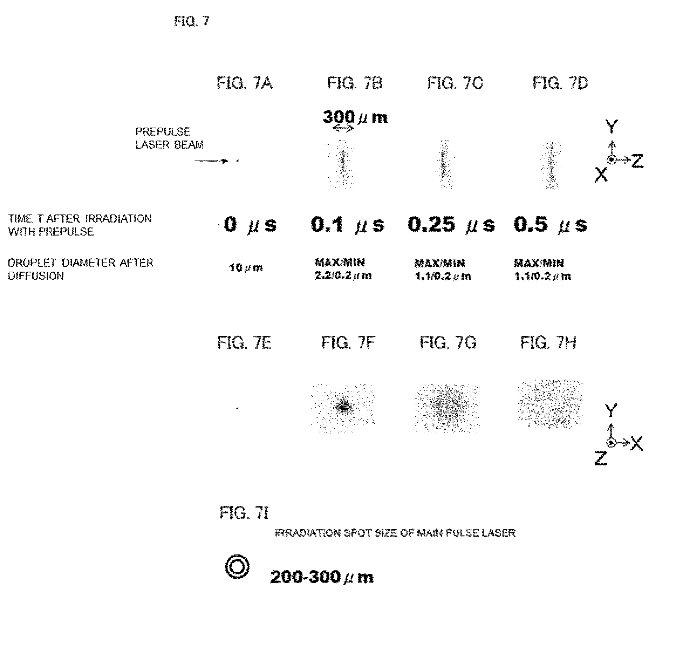

FIGS. 7A through 7H are diagrams illustrating simulation results of a state of the diffused target in a case in which the molten tin metal droplet having a diameter of 10 $\mu$m is irradiated with the prepulse laser beam. FIGS. 7A through 7D illustrate the state of the droplet and the diffused target as viewed in the direction (X-axis) perpendicular to the beam axis of the prepulse laser beam. FIGS. 7A through 7D illustrate the state of the target material at the time T after the irradiation with the prepulse laser beam when T is 0 $\mu$s, 0.1 $\mu$s, 0.25 $\mu$s, and 0.5 $\mu$s, respectively. FIGS. 7E through 7H illustrate the state of the droplet and the diffused target as viewed in the beam axis direction of the prepulse laser beam. FIGS. 7E through 7H illustrate the state of the target material after the times identical to the times for the cases illustrated in FIGS. 7A through 7D have elapsed, respectively. FIG. 7I illustrates the size of the irradiating spot of the main pulse laser beam at a position where the diffused target is irradiated with the main pulse laser beam. The illustrations are for a case in which the beam intensity of the prepulse laser beam is $1.5 \times 10^9$ W/cm$^2$.

When the simulation results illustrated in FIGS. 7A through 7H are observed with reference to the irradiating spot size of the main pulse laser beam illustrated in FIG. 7I, the following may be found. Most part of the diffused target may be irradiated with the main pulse laser beam at a timing approximately 0.1 $\mu$s after the irradiation with the prepulse laser beam. Accordingly, it may be conjectured that the generation of the debris may be reduced by taking measures so that the diffused target is irradiated with the main pulse laser beam at such a timing.

As illustrated in FIGS. 7A through 7D, the maximum value of the diameter of the microparticles in the diffused target after the irradiation with the prepulse laser beam is 2.2 $\mu$m after 0.1 $\mu$s from the irradiation with the prepulse laser beam, and 1.1 $\mu$m after 0.25 $\mu$s and after 0.5 $\mu$s from the irradiation with the prepulse laser beam. Hence, it may be conjectured that the maximum value of the diameter of the microparticles in the diffused target becomes constant after 0.25 $\mu$s from the irradiation with the prepulse laser beam. In addition, the minimum value of the diameter of the microparticles in the diffused target after the irradiation with the prepulse laser beam is 0.2 $\mu$m after each of 0.1 $\mu$s, 0.25 $\mu$s, and 0.5 $\mu$s from the irradiation with the prepulse laser beam. Hence, it may be conjectured that the diameter of the microparticles in the diffused target is sufficiently small after 0.1 $\mu$s from the irradiation with the prepulse laser beam. This suggests the possibility that, in a case in which the molten tin metal droplet is irradiated with the prepulse laser beam and the diffused target is irradiated with the main pulse laser beam approximately 0.1 $\mu$s after the irradiation with the prepulse laser beam, the CE may improve.

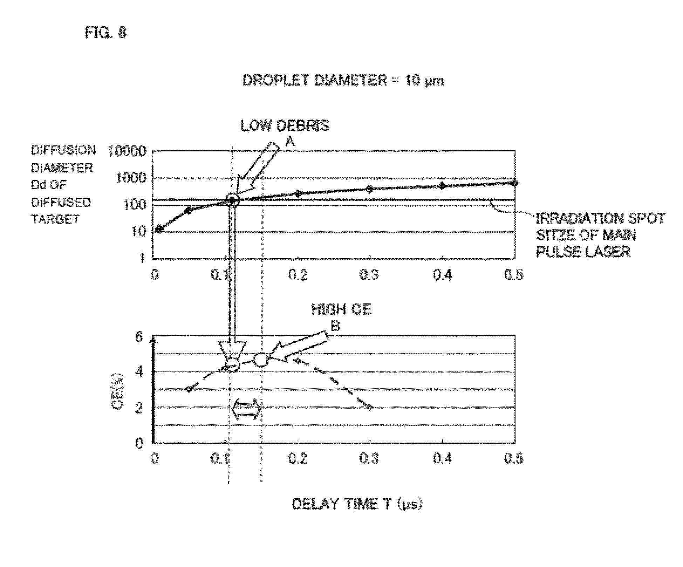

FIG. 8 is a diagram illustrating a change over time in the diffusion diameter Dd of the diffused target in a case in which the molten tin metal droplet having the diameter of 10 $\mu$m is irradiated with the prepulse laser beam, and the CE obtained when the diffused target is irradiated with the main pulse laser beam at a given timing.

As illustrated in FIG. 7, the diffusion diameter Dd of the diffused target after approximately 0.1 $\mu$s from the irradiation with the prepulse laser beam substantially coincides with the irradiating spot size of the main pulse laser beam. Accordingly, when the diffused target is irradiated with the main pulse laser beam after approximately 0.1 $\mu$s from the irradiation with the prepulse laser beam, there is a possibility that the generation of the debris may be reduced (arrow A in FIG. 8). On the other hand, FIG. 8 illustrates the possibility that a high CE may be obtained when the diffused target is irradiated with the main pulse laser beam after approximately 0.15 $\mu$s from the irradiation with the prepulse laser beam (arrow B). From this simulation result, it may be found that a difference between the value of the delay time for the main pulse laser beam that is desirable in order to reduce the generation of the debris and the value of the delay time for the main pulse laser beam that is desirable in order to obtain the high CE is relatively small. In other words, in the case in which the molten tin metal droplet having the diameter of 10 $\mu$m is irradiated with the prepulse laser beam, it may be predicted that simultaneously achieving the reduced debris and the high CE is possible. The molten tin metal droplet having the diameter of 10 $\mu$m may be referred to as a mass limited target because the droplet is in a sense a target having a minimum mass that is required to cause emission of the necessary EUV light.

<3. First Embodiment>

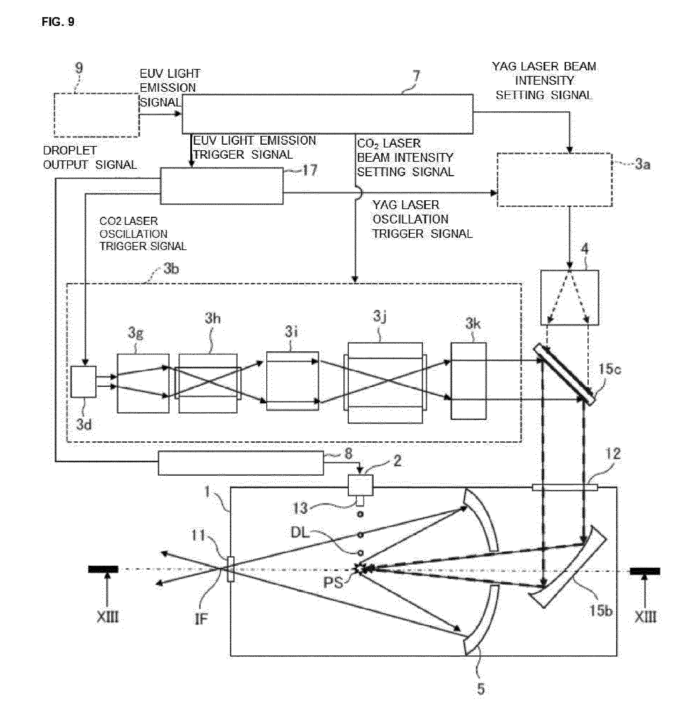

Next, a description will be given of each embodiment by referring to the accompanying drawings. FIG. 9 is a schematic diagram of an EUV light source apparatus in a first embodiment. The first embodiment has a configuration in which a beam axis of a prepulse laser beam output from a YAG pulse laser apparatus 3a and a beam axis of a main pulse laser beam output from a $CO_2$ pulse laser apparatus 3b are made to substantially coincide with each other by a beam combiner 15c. In other words, in the first embodiment, the prepulse laser beam and the main pulse laser beam are supplied into the chamber 1 via respective optical paths that are coaxial.

First, a EUV light emission signal is input from the exposure apparatus controller 9 to the EUV light source controller 7. The EUV light source controller 7 outputs a YAG laser beam intensity setting signal to the YAG pulse laser apparatus 3a. Further, the EUV light source controller 7 outputs a $CO_2$ laser beam intensity setting signal to the $CO_2$

pulse laser apparatus 3b.

In addition, the EUV light source controller 7 outputs an EUV light emission trigger signal to a trigger controller 17. The trigger controller 17 outputs a signal for outputting a droplet to the droplet controller 8. The droplet controller 8 inputs a droplet output signal to the target supplying part 2, and the target supplying part 2 outputs the droplet DL through the target nozzle 13. Moreover, the trigger controller 17 outputs a YAG laser oscillation trigger signal to the YAG pulse laser apparatus 3a. The YAG laser oscillation trigger signal is output so that the droplet DL is irradiated with the prepulse laser beam at a timing when the droplet DL arrives at the plasma generation site PS. Furthermore, the trigger controller 17 outputs a $CO_2$ laser oscillation trigger signal to a master oscillator 3d of the $CO_2$ pulse laser apparatus 3b. The $CO_2$ laser oscillation trigger signal is output so that the diffused target is irradiated with the main pulse laser beam at a timing after the delay time T from the time when the droplet DL is irradiated with the prepulse laser beam until the time when the desired diffused target is formed.

The YAG pulse laser apparatus 3a generates the prepulse laser beam at a first predetermined wavelength, based on the YAG laser beam intensity setting signal output from the EUV light source controller 7 and the YAG laser oscillation trigger signal output from the trigger controller 17. A beam diameter of the prepulse laser beam is expanded by a beam expander 4, before being input to the beam combiner 15c.

On a downstream side of each of the master oscillator 3d, a preamplifier 3h, and a main-amplifier 3j, the $CO_2$ pulse laser apparatus 3b includes relay optical systems 3g, 3i, and 3k, respectively, that are connected in series. The master oscillator 3d generates a seed beam including a second predetermined wavelength, based on the $CO_2$ pulse laser oscillation trigger signal. The seed beam output from the master oscillator 3d is amplified to a desired beam intensity by the preamplifier 3h and the main-amplifier 3j, based on the $CO_2$ laser beam intensity setting signal. The amplified laser beam is input to the beam combiner 15c as the main pulse laser beam.

The beam combiner 15c transmits the laser beam at the first predetermined wavelength and included in the laser beam output from the YAG pulse laser apparatus 3a, and reflects with high reflectance the laser beam at the second predetermined wavelength included in the laser beam output from the $CO_2$ pulse laser apparatus 3b. In this manner, the beam combiner 15c supplies the prepulse laser beam and the main pulse laser beam into the chamber 1 via the respective optical paths that are coaxial. The beam combiner 15c may be an optical element that transmits the laser beam at a wavelength of 1.06 $\mu$m of a YAG laser, and reflects with high reflectance the laser beam at a wavelength of 10.6 $\mu$m of a $CO_2$ laser. More particularly, a multi-layer coating having reflecting and transmitting characteristics described above may be coated on a diamond substrate. On the other hand, an optical element that reflects the YAG laser beam with high reflectance and transmits the $CO_2$ laser beam may be used in order to supply the prepulse laser beam and the main pulse laser beam via respective optical paths that are coaxial.

The droplet controller 8, the YAG pulse laser apparatus 3a, and the $CO_2$ pulse laser apparatus 3b operate in synchronization based on the various signals from the trigger controller 17 described above. Hence, the YAG pulse laser apparatus 3a outputs the prepulse laser beam at a timing when the target material supplied into the chamber 1 by the target supplying part 2 reaches a predetermined position. In addition, the $CO_2$ pulse laser apparatus 3b outputs the main pulse laser beam at a timing when the desired diffused target is formed by the irradiation with the prepulse laser beam.

According to the first embodiment, the prepulse laser beam and the main pulse laser beam may reach the plasma generation site (PS) in substantially the same direction, and thus, apertures formed in the EUV collector mirror 5 may be made small in size and also small in number.

In addition, the wavelength (for example, 1.06 $\mu$m) of the prepulse laser beam output from the YAG pulse laser apparatus 3a becomes 1/10 or less of the wavelength (for example, 10.6 $\mu$m) of the main pulse laser beam output from the $CO_2$ pulse laser apparatus 3b. The following advantageous features may be obtained because the wavelength of the prepulse laser beam is sufficiently shorter compared to the wavelength of the main pulse laser beam. (1) With respect to the target material, such as tin, the absorptance of the prepulse laser beam may be made higher than the absorptance of the main pulse laser beam. (2) The irradiating spot size of the prepulse laser beam focused on the droplet may be made small. As a result, the prepulse laser beam may efficiently diffuse the droplet DL using small pulse energy. Other features have been described above with reference to FIG. 1.

<4. Second Embodiment>

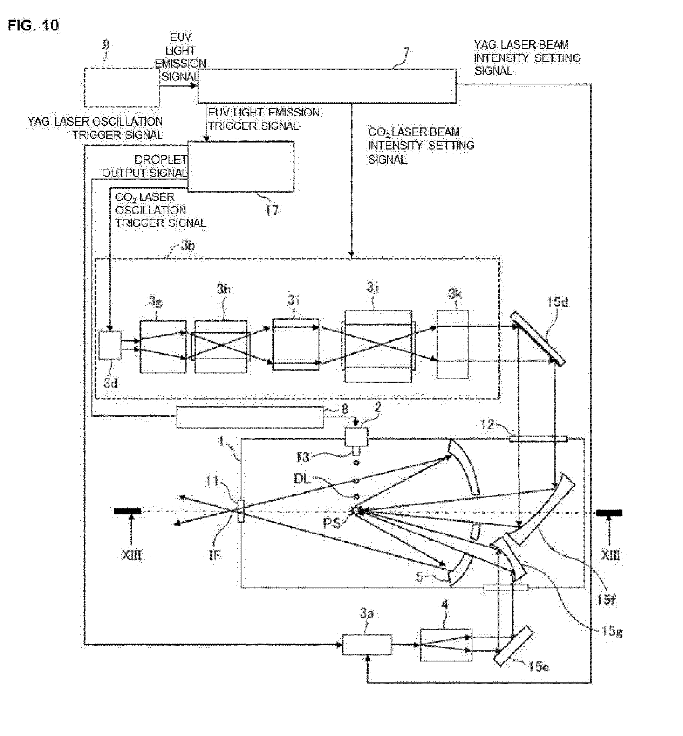

FIG. 10 is a schematic diagram of an EUV light source apparatus in a second embodiment. The second embodiment has a configuration in which the prepulse laser beam output from the YAG pulse laser apparatus 3a and the main pulse laser beam output from the $CO_2$ pulse laser apparatus 3b are supplied into the chamber 1 via separate routes.

The prepulse laser beam output from the YAG pulse laser apparatus 3a is focused on the droplet inside the chamber 1 via a high reflection mirror 15e, an off-axis paraboloidal mirror 15g, and one through-hole formed in the EUV collector mirror 5. Hence, the diffused target is formed.

The main pulse laser beam output from the $CO_2$ pulse laser apparatus 3b is focused on the diffused target that is formed by the irradiation with the prepulse laser beam inside the chamber 1 via a high reflection mirror 15d, an off-axis paraboloidal mirror 15f, and another through-hole formed in the EUV collector mirror 5.

According to the second embodiment, beam spots of the prepulse laser beam and the main pulse laser beam may be formed to desired sizes with ease, because the target is irradiated with the prepulse laser beam and the main pulse laser beam via separate optical systems. In addition, it is unnecessary to use an optical element, such as the beam combiner, for supplying the prepulse laser beam and the main pulse laser beam via optical paths that are coaxial. Still, the droplet DL may be irradiated with the prepulse laser beam and the diffused target may be irradiated with the main pulse laser beam, respectively, from substantially the same direction. Other features may be the same as those of the first embodiment.

<5. Third Embodiment>

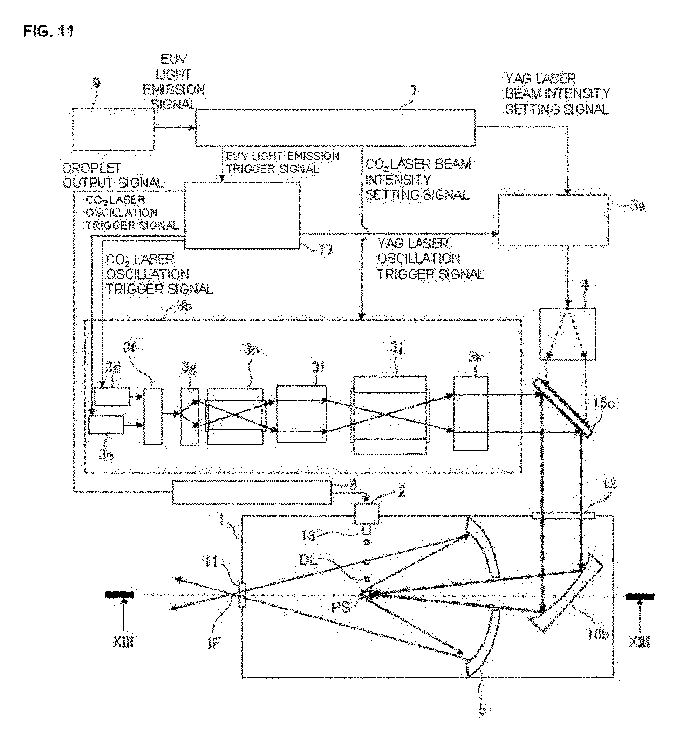

FIG. 11 is a schematic diagram of an EUV light source apparatus in a third embodiment. The third embodiment has a configuration in which a first prepulse laser beam output from the YAG pulse laser apparatus 3a, and a second prepulse laser beam and the main pulse laser beam output from the $CO_2$ pulse laser apparatus 3b are supplied into the chamber 1.

The $CO_2$ pulse laser apparatus 3b includes, in addition to the master oscillator 3d to generate the seed beam of the main pulse laser beam, a master oscillator 3e to generate a seed beam of the second prepulse laser beam. The seed beam of the second prepulse laser beam output from the master oscillator 3e is amplified to desired beam intensity by the preamplifier 3h and the main-amplifier 3j. The amplified beam is input to the beam combiner 15c as the second prepulse laser beam. The seed beam of the main pulse laser beam output from the master oscillator 3d is also amplified to desired beam intensity by the preamplifier 3h and the main-amplifier 3j. This amplified beam is also input to the beam combiner 15c as the main pulse laser beam.

The master oscillators 3d and 3e may each be a semiconductor laser that oscillates in a bandwidth amplifiable in a $CO_2$ laser medium. Specifically, a plurality of quantum cascade lasers may be used as the master oscillators 3d and 3e.

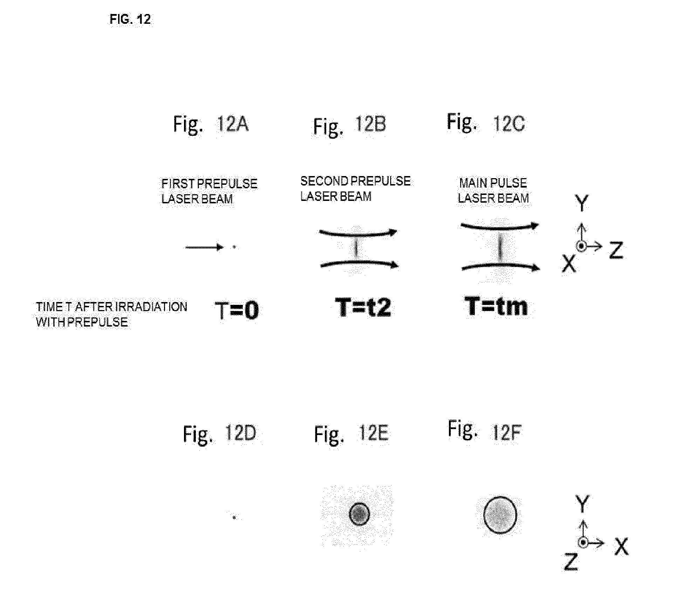

FIGS. 12A through 12F are schematic diagrams illustrating a state of a diffused target in a case in which the droplet DL is irradiated with the first prepulse laser beam and the irradiated droplet DL is further irradiated with the second prepulse laser beam. FIGS. 12A through 12C illustrate the droplet and the diffused target that are viewed in a direction (X-axis) perpendicular to beam axes of the first and second prepulse laser beams, and illustrate the state of the target material at the delay time T of T=0, T=t2, and T=tm (where 0<t2<tm), respectively, after the irradiation with the first prepulse laser beam. FIGS. 12D through 12F illustrate the droplet and the diffused target as viewed in the direction of the beam axes of the first and second prepulse laser beams, and illustrate the state of the target material after the times identical to the times for the cases illustrated in FIGS. 12A through 12C have elapsed, respectively.

First, when the droplet of the target material illustrated in FIGS. 12A and 12D is irradiated with the first prepulse laser beam, the droplet diffuses as illustrated in FIGS. 12B and 12E to form a first diffused target. The first diffused target is irradiated with the second prepulse laser beam at a timing when the first diffused target formed by the first prepulse laser beam becomes a desired diffusion diameter that is the same as or smaller than the irradiating spot size of the second prepulse laser beam.

When the first diffused target is irradiated with the second prepulse laser beam, each of the particles of the first diffused target is pulverized into even smaller microparticles and diffused as illustrated in FIGS. 12C and 12F, to form a second diffused target. The second diffused target (desired diffused target) is irradiated with the main pulse laser beam at a timing when the second diffused target formed by the irradiation with the second prepulse laser beam becomes a diffused target having a desired diffusion diameter that is the same as or smaller than the irradiation spot size of the main pulse laser beam.

Accordingly, the second diffused target that is formed by the irradiation with the first and second prepulse laser beams is irradiated with the main pulse laser beam. Because the second diffused target in which the existing microparticles that are even smaller compared to those of the first diffused target is irradiated with the main pulse laser beam, the energy of the main pulse laser beam is efficiently absorbed by the second diffused target. Hence, a large portion of the second diffused target is turned into plasma, and thus, a high CE may be obtained. Further, by making the irradiation spot size of the main pulse laser beam the same as the diffusion diameter of the second diffused target, the high CE and the reduced debris may be achieved simultaneously. Other features may be the same as those of the first embodiment.

In the third embodiment, it is preferable to use a mass limited target, such as molten tin metal having a diameter of approximately 10 $\mu$m, for example.

In the example of the third embodiment, the diffused target is irradiated with the main pulse laser beam after the target material is irradiated with the prepulse laser beams in two stages; however, the target material may be irradiated with the prepulse laser beams in three or more stages.

In addition, in the example of the third embodiment, the first prepulse laser beam is output from the YAG pulse laser apparatus 3a, and the second prepulse laser beam and the main pulse laser beams are output from the $CO_2$ pulse

laser apparatus 3b; however, these laser beams may be output from a single pulse laser apparatus, such as a $CO_2$ laser apparatus.

Furthermore, the first and second prepulse laser beams may be output from a first laser apparatus, and the main pulse laser beam may be output from a second laser apparatus. In this case, the first laser apparatus may be a YAG laser apparatus or a fiber laser apparatus, for example, and the second laser apparatus may be a $CO_2$ laser apparatus, for example.

<6. Fourth Embodiment>

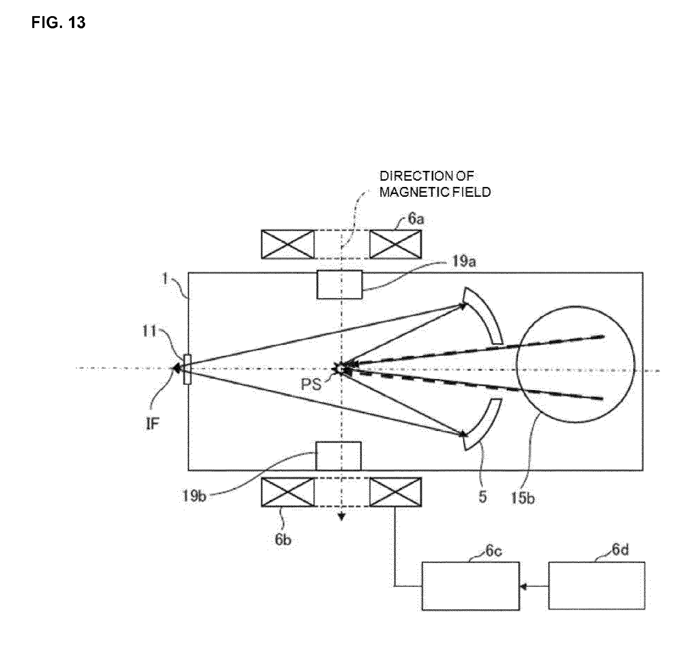

FIG. 13 is a schematic diagram of an EUV light source apparatus in a fourth embodiment. FIG. 13 illustrates a cross section taken along a line XIII-XIII in FIGS. 9 through 11. The fourth embodiment has a configuration in which ions generated inside the chamber 1 are collected by generating a magnetic field inside the chamber 1 by magnets 6a and 6b, in the first through third embodiments described above.

The magnets 6a and 6b are electromagnets including coil winding, a cooling mechanism for the coil winding, and so forth. A power supply unit 6c controlled by a power supply controller 6d is connected to these magnets 6a and 6b. A magnetic field in a predetermined direction is formed inside the chamber 1 by adjusting a current supplied from the power supply unit 6c to the magnets 6a and 6b by the power supply controller 6d. For example, a superconducting magnet may be used for the magnets 6a and 6b. Two magnets 6a and 6b are used in this example; however, one electromagnet may be used. Further, a permanent magnet may be arranged inside the chamber.

The plasma generated by irradiating the target material with the main pulse laser beam includes positive ions and negative ions (or electrons). The positive ions and the negative ions moving inside the chamber 1 receive the Lorentz force in the magnetic field, and thus, the positive ions and the negative ions move spirally along the lines of magnetic force. Hence, the ionized target material is trapped by the magnetic field, and collected by ion collection units 19a and 19b provided in the magnetic field. Accordingly, the debris inside the chamber 1 may be reduced, and the deterioration of the optical elements inside the chamber, such as the EUV collector mirror 5, caused by the debris depositing on the optical elements, may be suppressed. In FIG. 13, the magnetic field is oriented in the direction of an arrow; however, the same function may be realized when the magnetic field is oriented in a direction opposite to the direction of the arrow.

The mitigation technique to reduce the deposition of the debris on the optical element is not limited to that using the magnetic field, and may use an etching gas to etch the material deposited on the EUV collector mirror 5 or the like. In addition, the mitigation technique may cause a hydrogen gas ($H_2$) or a hydrogen radical (H) to react with the debris, in order to remove a gasified compound of the debris.

<7. Fifth Embodiment>

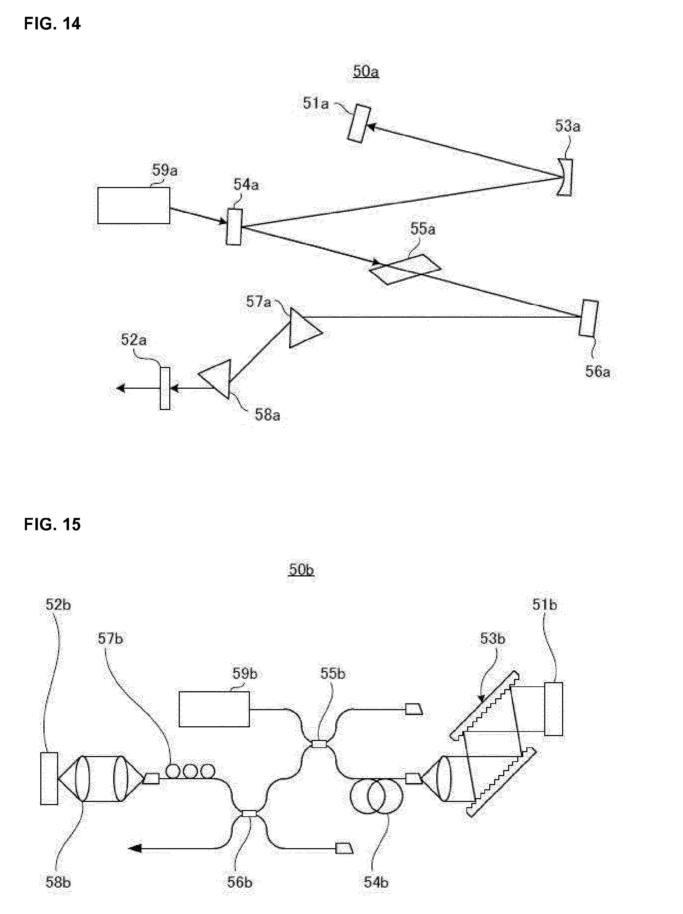

FIG. 14 is a schematic diagram illustrating an example of the configuration of a titanium-sapphire laser that generates a prepulse laser beam in an EUV light source apparatus in a fifth embodiment. A titanium-sapphire laser 50a in the fifth embodiment is provided outside the chamber as a driver laser that generates the prepulse laser beam to diffuse the droplet in the first through fourth embodiments described above.

The titanium-sapphire laser 50a in the fifth embodiment includes a laser resonator that is formed by a semiconductor saturable absorber mirror 51a and an output coupling mirror 52a. The laser resonator includes a concave mirror 53a, a first pumping mirror 54a, a titanium-sapphire crystal 55a, a second pumping mirror 56a, and two prisms 57a and 58a that are arranged in this order from the side of the semiconductor saturable absorber mirror 51a. Further, the titanium-sapphire laser 50a includes an excitation light source 59a to introduce excitation light into the laser resonator.

The first pumping mirror 54a transmits the excitation light from the outside of the laser resonator, and reflects the light from the inside of the laser resonator with high reflectance. The titanium-sapphire crystal 55a is a laser medium that undergoes a stimulated emission in response to the excitation light. The two prisms 57a and 58a selectively transmit light at a particular wavelength, respectively. The output coupling mirror 52a transmits and outputs a portion of the light amplified in the laser resonator, and reflects a remaining portion of the light back into the laser resonator. The semiconductor saturable absorber mirror 51a includes a reflection layer and a saturable absorber layer laminated on a mirror substrate, and the saturable absorber layer absorbs incident light while the incident light is weak. When the incident light on the semiconductor saturable absorber mirror 51a becomes strong, the saturable absorber layer transmits the incident light and the reflection layer reflects the incident light, in order to reflect the incident light as short pulses.

For example, a semiconductor excitation Nd: $YVO_4$ (neodymium-doped yttrium orthovanadate) laser may be used for the excitation light source 59a. The second harmonic from the excitation light source 59a is input to the first pumping mirror 54a, and the position of the semiconductor saturable absorber mirror 51a is adjusted, in order to produce the oscillation by synchronizing the resonator length and the longitudinal mode of the laser resonator. Hence, a pulse laser beam having a pulse duration on the picosecond order or less is output from the output coupling mirror 52a. In a case in which the pulse energy is small, the pulse laser beam may be amplified by a regenerative amplifier or the like.

According to the fifth embodiment, the target material may be irradiated with a short pulse laser beam having a pulse duration on the picosecond order or less as the prepulse laser beam. When the target material is irradiated with the short pulse laser light, there is a possibility of making the thermal diffusion at the irradiated part extremely small, and the energy that may cause the thermal diffusion may be utilized for the ablation effect. As a result, according to the fifth embodiment, the droplet may be diffused by a pulse energy that is smaller compared to that of the nanosecond order laser beam.

<8. Sixth Embodiment>

FIG. 15 is a schematic diagram illustrating an example of the configuration of a fiber laser that generates a prepulse laser beam in an EUV light source apparatus in a sixth embodiment. A fiber laser 50b in the sixth embodiment is provided outside the chamber as a driver laser that generates the prepulse laser beam to diffuse the droplet in the first through fourth embodiments described above.

The fiber laser 50b in the sixth embodiment includes a laser resonator that is formed by a high reflection mirror 51b and a semiconductor saturable absorber mirror 52b. The laser resonator includes a grating pair 53a, a first polarization maintenance fiber 54b, a multiplexer 55b, a separator element 56b, a second polarization maintenance fiber 57b, and a focusing optical system 58b that are arranged in this order from the side of the high reflection mirror 51b. Further, the fiber laser 50b includes an excitation light source 59b to introduce excitation light into the laser resonator.

The multiplexer 55b introduces the excitation light from the excitation light source 59b to the first polarization maintenance fiber 54b, and transmits the light traveling between the first polarization maintenance fiber 54b and the second polarization maintenance fiber 57b. The first polarization maintenance fiber 54b is doped with ytterbium (Yb), and undergoes a stimulated emission in response to the excitation light. The grating pair 53b selectively reflects light at a particular wavelength through the diffraction effect. The semiconductor saturable absorber mirror 52b includes a reflection layer and a saturable absorber layer laminated on a substrate, and the saturable absorber layer absorbs incident light while the incident light is weak. When the incident light on the semiconductor saturable absorber mirror 52b becomes strong, the saturable absorber layer transmits the incident light and the reflection layer reflects the incident light, in order to reflect the incident light as short pulses. The separator element 56b separates and outputs a portion of the light amplified in the laser resonator, and returns a remaining portion of the light back into the laser resonator. When the excitation light is introduced to the multiplexer 55b from the excitation light source 59b that is connected to the multiplexer 55b through an optical fiber, the pulse laser beam having the pulse duration on the picosecond order is output via the separator element 56b.

A picosecond pulse laser that outputs the pulse laser beam having the pulse duration on the picosecond order is formed by a pulse laser outputting a pulse laser beam having a pulse duration T of less than 1 ns (T < 1 ns). Further, effects similar to those described above may be obtained when a femtosecond pulse laser that outputs the pulse laser beam having the pulse duration on the femtosecond order is applied to the present disclosure.

According to the sixth embodiment, effects similar to those of the fifth embodiment may be obtained, and in addition, it becomes possible to easily irradiate the target material with the pulse laser beam with high precision. Generally, in the case of the fiber laser, a $M^2$ value representing a deviation of the laser beam intensity distribution from an ideal Gaussian distribution is on the order of 1.2. The focusing performance is higher as the $M^2$ value takes a value closer to 1. For this reason, by using the fiber laser, a small target may be irradiated with the prepulse laser beam on with high precision.

As the wavelength of the laser beam becomes shorter, the laser beam absorptance by tin becomes higher. Accordingly, when placing importance on the absorptance by tin, the short wavelength is more advantageous. For example, with respect to the fundamental wavelength of 1064 nm output from an Nd: YAG (neodymium-doped yttrium aluminum garnet) laser, the absorptance becomes higher for the harmonics $2\omega = 532$ nm, $3\omega = 355$ nm, and $4\omega = 266$ nm in this order.

Although this example uses the short pulse laser beam having the pulse duration on the picosecond order, the droplet may also be diffused using the pulse laser beam having the pulse duration on the nanosecond order. For example, a fiber laser having a pulse duration of approximately 15 ns, a repetition rate of 100 kHz, pulse energy of 1.5 mJ, a wavelength of 1.03 $\mu$m, and a $M^2$ value of less than 1.5 is sufficiently usable as the prepulse laser.

<9. Irradiating Conditions of Laser Beam>

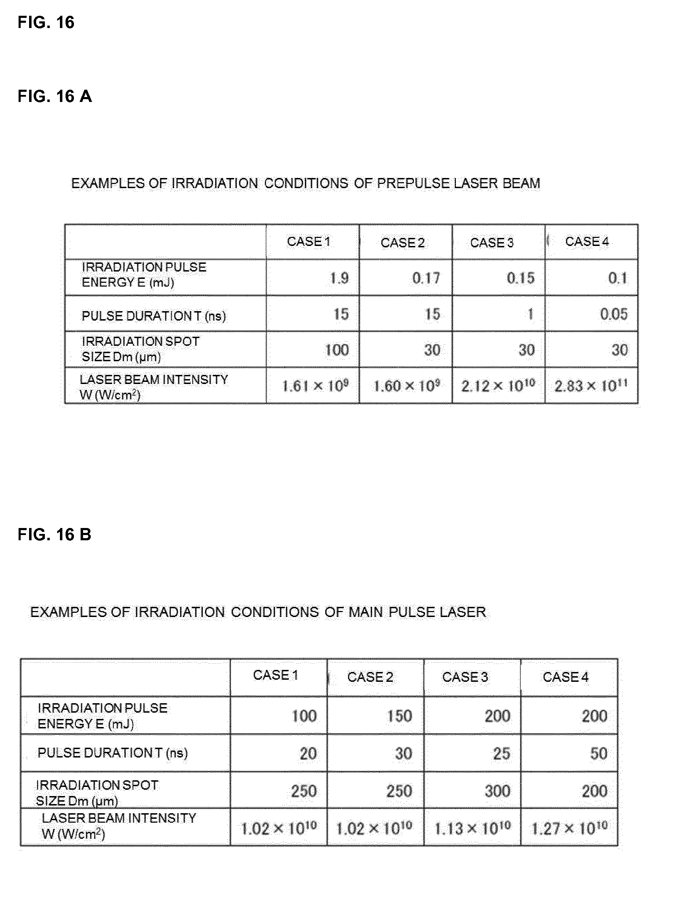

FIGS. 16A and 16B are tables illustrating examples of laser beam irradiating conditions in the EUV light source apparatuses described above. When the irradiating pulse energy is denoted by E (J), the pulse duration by T (s), and the irradiating spot size by Dm (m), beam intensity W ($W/m^2$) of the laser beam may be represented by the following formula (5).

$$W = E/(T(Dm/2)^2\pi) \qquad\qquad --- \text{Formula (5)}$$

FIG. 16A illustrates four examples (cases 1 through 4) of the irradiating conditions of the prepulse laser beam. It is supposed in the case 1 that the diameter of the molten tin metal droplet is 60 $\mu$m, for example. The irradiating conditions for generating the desired diffused target by diffusing such a droplet are as follows. For example, in a case in which the irradiating spot size Dm of the droplet is 100 $\mu$m and the required beam intensity W of the laser beam is $1.6 \times 10^9$ W/cm$^2$, the irradiating pulse energy E and the pulse duration T may be set to 1.9 mJ and 15 ns, respectively. The diffused target illustrated in FIG. 3B may be generated using such a prepulse laser beam.

It is supposed in the case 2 illustrated in FIG. 16A that the diameter of the molten tin metal droplet is 10 $\mu$m, for example, which corresponds to the size of the mass limited target. The irradiating conditions for generating the desired diffused target by diffusing such a droplet are as follows. For example, in a case in which the irradiating spot size Dm of the droplet is 30 $\mu$m and the required beam intensity W of the laser beam is $1.6 \times 10^9$ W/cm$^2$, the irradiating pulse energy E and the pulse duration T may be set to 0.17 mJ and 15 ns, respectively. The diffused target illustrated in FIG. 7B may be generated using such a prepulse laser beam.

The case 3 and the case 4 illustrated in FIG. 16A are examples using the laser apparatuses illustrated in FIGS. 14 and 15, respectively, as the laser apparatus that generates the prepulse laser beam. The case 3 and the case 4 may be applied in a case in which the droplet has the size corresponding to the mass limited target and the beam intensity W of the laser beam is $1 \times 10^{10}$ W/cm$^2$ or higher.

FIG. 16B illustrates four examples (cases 1 through 4) of the irradiating conditions of the main pulse laser beam. It is supposed in the case 1 that the diameter of the diffused target is 250 $\mu$m, for example. The irradiating conditions for turning such a diffused target into plasma are as follows. For example, in a case in which the irradiating spot size Dm of the diffused target is 250 $\mu$m and the required beam intensity W of the laser beam is $1.0 \times 10^{10}$ W/cm$^2$, the irradiating pulse energy E and the pulse duration T may be set to 100 mJ and 20 ns, respectively. As a result, the energy required for turning the diffused target into plasma is supplied to the diffused target.

It is supposed in the case 2 illustrated in FIG. 16B that the diameter of the diffused target, the irradiating spot size Dm, and the beam intensity W of the laser beam are the same as those of the case 1 illustrated in FIG. 16B, and the irradiating pulse energy E and the pulse duration T may be set to 150 mJ and 30 ns, respectively. As a result, the energy required for turning the diffused target into plasma is supplied to the diffused target.

It is supposed in the case 3 illustrated in FIG. 16B that the diameter of the diffused target is 300 $\mu$m, for example. The irradiating conditions for turning such a diffused target into plasma are as follows. For example, in a case in which the irradiating spot size Dm of the diffused target is 300 $\mu$m and the required beam intensity W of the laser beam is $1.00 \times 10^{10}$ W/cm$^2$, the irradiating pulse energy E and the pulse duration T may be set to 200 mJ and 25 ns, respectively. As a result, the energy required for turning the diffused target into plasma is supplied to the diffused target.

It is supposed in the case 4 illustrated in FIG. 16B that the diameter of the diffused target is 200 $\mu$m, for example. The irradiating conditions for turning such a diffused target into plasma are as follows. For example, in a case in which the irradiating spot size Dm of the diffused target is 200 $\mu$m and the required beam intensity W of the laser beam is $1.00 \times 10^{10}$ W/cm$^2$, the irradiating pulse energy E and the pulse duration T may be set to 200 mJ and 50 ns, respectively. As a result, the energy required for turning the diffused target into plasma is supplied to the diffused target.

Therefore, the beam intensity of the prepulse laser beam and the main pulse laser beam may respectively be set by setting the irradiating pulse energy E and the pulse duration T of the laser beam.

<10. Seventh Embodiment>

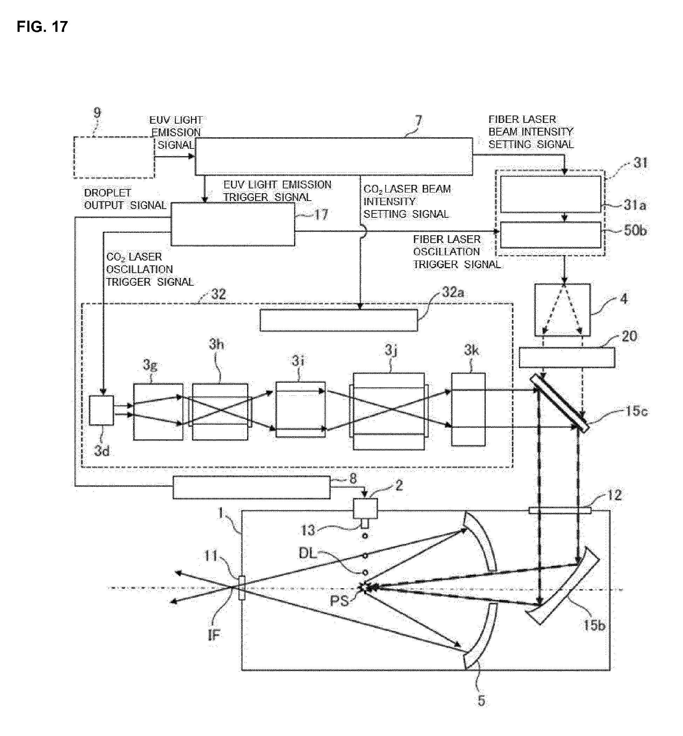

FIG. 17 is a schematic diagram illustrating an EUV light source apparatus in a seventh embodiment. The seventh embodiment has a configuration in which a polarization state of the prepulse laser beam output from a fiber laser system 31 is varied by a polarizer 20. The polarizer 20 is an element that changes the polarization state of the prepulse laser beam into a polarization state other than the linearly polarized state. The polarizer 20 may be provided at a predetermined position in an optical path between the driver laser and the plasma generation site (PS). In this specification, the polarizer includes a polarization retarder.

In the seventh embodiment, the fiber laser system 31 may include a fiber laser controller 31a, and the fiber laser 50b described above with reference to FIG. 15 (sixth embodiment). A $CO_2$ pulse laser system 32 may include a $CO_2$ laser controller 32a, and the master oscillator 3d, the preamplifier 3h, the main-amplifier 3j, and the relay optical systems 3g, 3i and 3k described above with reference to FIG. 9 (first embodiment).

The EUV light source controller 7 outputs a fiber laser beam intensity setting signal to the fiber laser controller 31a. Further, the EUV light source controller 7 outputs a $CO_2$ laser beam intensity setting signal to the $CO_2$ laser controller 32a.

The trigger controller 17 outputs a fiber laser oscillation trigger signal to the fiber laser 50b. Further, the trigger controller 17 outputs a $CO_2$ laser oscillation trigger signal to the master oscillator 3d.

The fiber laser 50b outputs the prepulse laser beam at a first predetermined wavelength, based on the fiber laser oscillation trigger signal. The fiber laser controller 31a controls output intensity of the fiber laser 50b based on the fiber laser beam intensity setting signal. The prepulse laser beam output from the fiber laser 50b is expanded of the beam diameter thereof by the beam expander 4, and becomes incident to the beam combiner 15c after being changed of the polarization state thereof by the polarizer 20.

The master oscillator 3d outputs a seed beam including a second predetermined wavelength component based on the $CO_2$ pulse laser oscillation trigger signal. The $CO_2$ laser controller 32a controls output intensity of the preamplifier 3h and the main-amplifier 3j based on the $CO_2$ laser beam intensity setting signal. The seed beam output from the master oscillator 3d is amplified to desired beam intensity by the preamplifier 3h and the main-amplifier 3j.

Other features may be the same as those of the first embodiment. The seventh embodiment is described above for the case in which the fiber laser 50b is used as the light source of the prepulse laser beam; however, the present disclosure is not limited to such a case. For example, a YAG laser or a titanium-sapphire laser may be used as the light source of the prepulse laser beam. Alternatively, a configuration may be employed in which a first prepulse laser beam is output from a fiber laser apparatus that may easily realize a small spot size, a second prepulse laser beam is output from a YAG laser apparatus or a titanium-sapphire laser apparatus that may easily obtain ultrashort pulse laser beam, and a main pulse laser beam is output from a $CO_2$ laser apparatus that may realize high output laser beam. In other words, a desired number of prepulse laser beams may be output from a plurality of different laser apparatuses. In addition, depending on the state of the diffused target at a point in time when the diffused target is irradiated with the prepulse laser beam, the diffused target may be irradiated with prepulse laser beams having different spot size, energies, wavelengths, pulse durations, and so forth a plurality of times.

<10-1. Summary of Polarization Control>

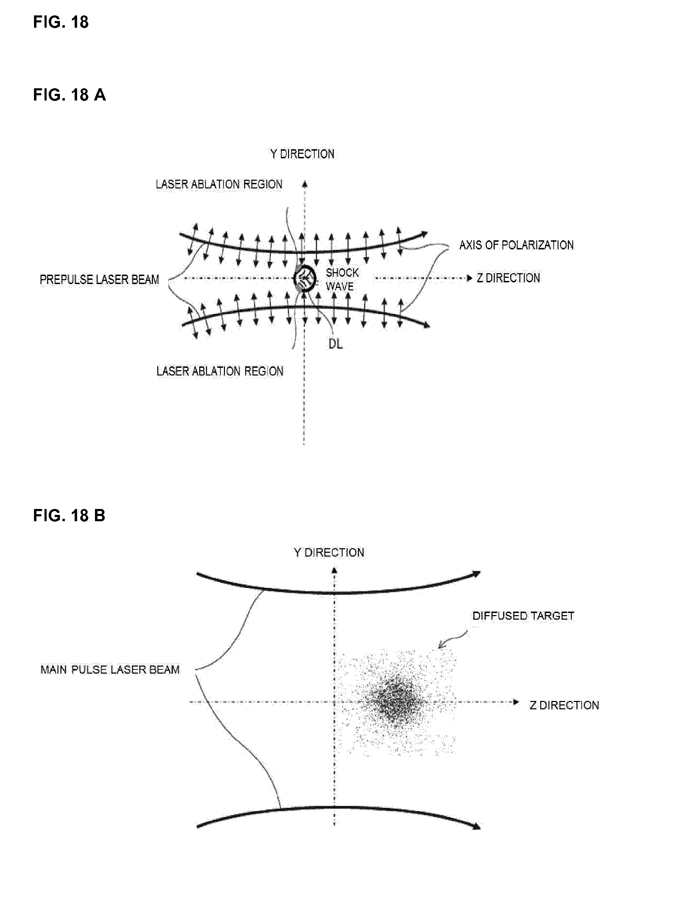

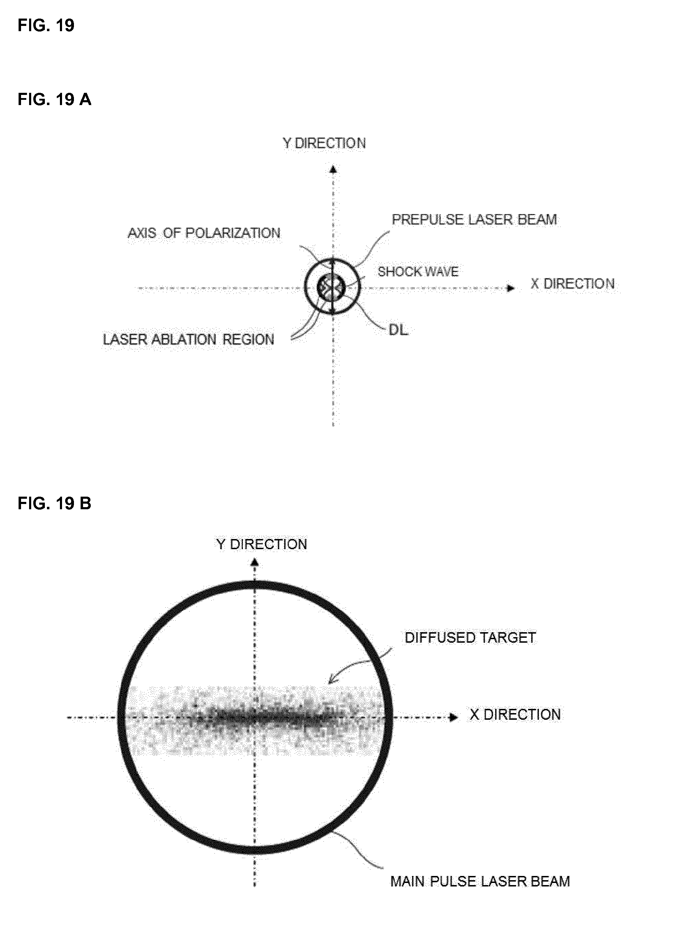

FIGS. 18A and 19A are schematic diagrams illustrating a state in which the droplet is irradiated with a linearly polarized prepulse laser beam. FIGS. 18B and 19B are diagrams illustrating a simulation result of the diffused state of the droplet when the droplet is irradiated with the linearly polarized prepulse laser beam. FIGS. 18A and 18B illustrate views in a direction (X direction) perpendicular to the polarization direction of the prepulse laser beam, and FIGS. 19A and 19B illustrate views in a beam axis direction (Z direction) of the prepulse laser beam.

A case will be considered in which the droplet is irradiated with a linearly polarized prepulse laser beam. In this case, the droplet diffuses, to generate the diffused target as illustrated in FIGS. 18B and 19B. It may be observed from this simulation result that a spread of the diffused target in the direction (X direction) perpendicular to the polarization direction of the prepulse laser beam is larger compared to a spread of the diffused target in the polarization direction (Y direction). In a case in which the diffused target having such a shape is irradiated with the main pulse laser beam in substantially the same direction as the prepulse laser beam, the shape of the diffused target and the cross sectional shape of the main pulse laser beam become different, as illustrated in FIGS. 18B and 19B. For this reason, there is a high possibility that a larger portion of the main pulse laser beam will not be utilized for the plasma generation.

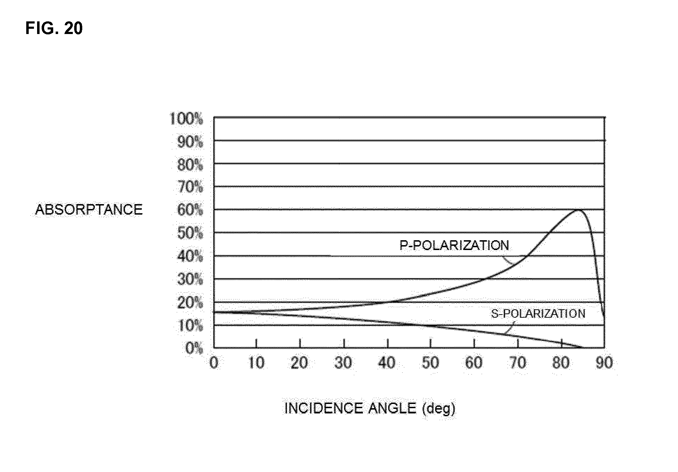

A cause of the diffused droplet greatly spreading in the direction (X direction) perpendicular to the polarization direction of the linearly polarized prepulse laser beam will be examined. FIG. 20 is a graph illustrating an absorptance of incident P-polarized and S-polarized laser beams with respect to the surface of the molten tin metal droplet. In FIG. 20, the laser beam is assumed to have a wavelength of 1.06 $\mu$m. As illustrated in FIG. 20, it may be regarded that the absorptance of the laser beam depends on an incident angle and the polarization state of the laser beam.

The absorptance of the laser beam incident with the P-polarization is highest when the incident angle to the surface of the molten tin metal droplet is 80° to 85°, and the absorptance of the laser beam incident with the P-polarization decreases as the incident angle deviates outside this angular range. On the other hand, the absorptance of the laser beam incident with the S-polarization when the incident angle to the surface of the molten tin metal droplet is approximately 0°, that is, the laser beam incident with the S-polarization is approximately perpendicular to the surface of the droplet, the absorptance of the laser beam incident with the S-polarization is substantially equal to the absorptance incident with the P-polarization, and the absorptance of the laser beam incident with the S-polarization decreases as the incident angle increases. For example, when the incident angle is 80° or greater, the absorptance of the laser beam incident with the S-polarization becomes close to 0%.

From the absorptance characteristics described above, the droplet irradiated with the linearly polarized prepulse laser beam absorbs the energy of the laser beam the most at the part of the droplet where the laser beam is incident with the P-polarization at an incident angle of 80° to 85°. The part of the surface of the droplet irradiated with the laser beam that is incident with the P-polarization at the incident angle of 80° to 85° is located near end parts in the Y direction of a hemispherical surface on the side of the droplet receiving the laser irradiation, as illustrated in FIGS. 18A and 19A. In other words, it may be assumed that the absorptance of the laser beam is high at these parts of the surface of the droplet, and that a strong laser ablation occurs at these parts. As a result of an ablation reaction in a laser ablation region (near the end parts in the Y direction of the hemispherical surface on the side of the droplet receiving the laser irradiation), a shock wave is generated from the ablation region toward the inside of the droplet. This shock wave propagates toward end parts in the X-axis direction of the droplet illustrated in FIG. 19A, and the droplet is diffused in the X direction in FIG. 19A. It may be assumed that cause of the diffused droplet spreading widely in the direction (X direction) perpendicular to the polarization direction of the linearly polarized prepulse laser beam, but not much in the polarization direction (Y direction), is as described above.

Hence, in the seventh embodiment, the polarizer 20 is used to change the polarization state of the prepulse laser beam to become a polarization state other than the linearly polarized state. In addition, by making the spot size of the prepulse laser beam greater than or equal to the diameter (for example, 40 $\mu$m) of the droplet, it becomes possible to irradiate the entire laser side surface of the droplet with the prepulse laser beam. Accordingly, the droplet may be diffused symmetrically with respect to the beam axis of the prepulse laser beam, and the diffused droplet may be irradiated with the main pulse laser beam efficiently.

For example, the polarizer 20 may change the polarization state of the prepulse laser beam into a substantially circularly polarized state, a spatially random linearly polarized state in which a polarization orientation at a plurality of parts of a cross section perpendicular to the beam axis is mutually perpendicular, a radially polarized state, an azimuthally polarized state, and so forth.

<10-2. Example of Polarization Control>

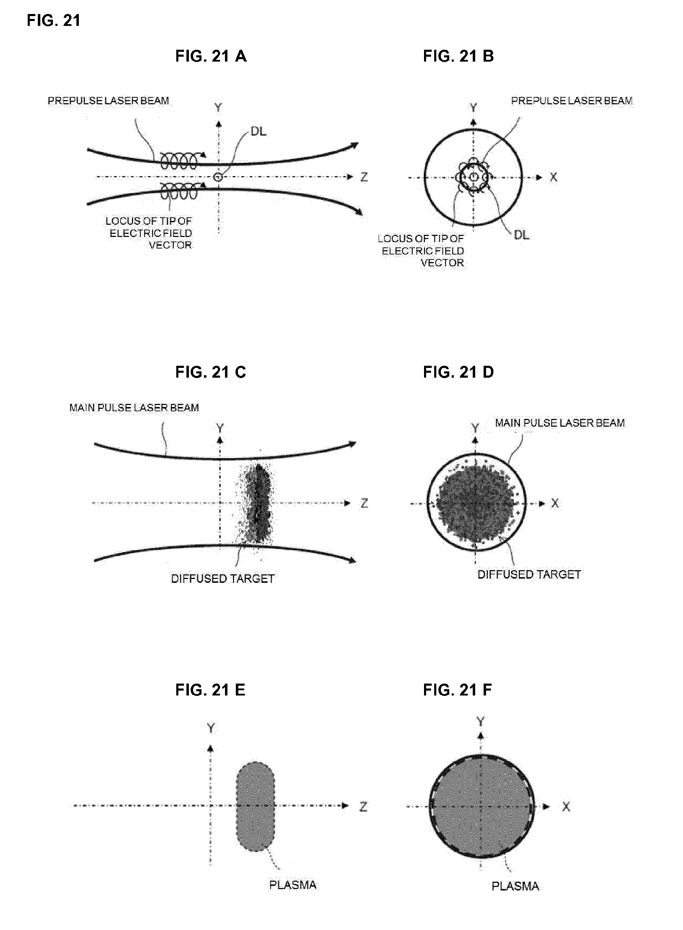

FIGS. 21A through 21F are schematic diagrams illustrating a state in which the droplet is irradiated with a circularly polarized prepulse laser beam and the diffused droplet is irradiated with the main pulse laser beam in the seventh embodiment. FIGS. 21A and 21B illustrate the state in which the droplet is irradiated with the circularly polarized prepulse laser beam. FIGS. 21C and 21D illustrate the state in which the droplet that is diffused by the irradiation with the prepulse laser beam is irradiated with the main pulse laser beam. FIGS. 21E and 21F illustrate the state in which the plasma is generated by the irradiation with the main pulse laser beam.

In the circularly polarized beam, a locus of a tip end of an electric field vector depicts a spiral, and a circle is depicted when this locus is projected onto a plane (XY plane) perpendicular to the beam axis. In addition, the polarization state is the circular polarization state at all positions on the XY plane cross section of the prepulse laser beam (FIGS. 21A and 21B). In the circularly polarized beam, a ratio of the beam intensity of a polarization component in the X direction and a polarization component in the Y direction becomes substantially 1:1. When the droplet is irradiated with such a circularly polarized prepulse laser beam, a distribution of the absorptance of the prepulse laser beam on the droplet surface becomes symmetrical with respect to the center axis of the droplet. As a result, the diffused state of the droplet becomes symmetrical with respect to the center axis of the droplet, and for example, the shape of the diffused target becomes a disk shape (FIGS. 21C and 21D). Hence, the shape of the diffused target substantially coincides with the cross sectional shape of the main pulse laser beam, and the diffused target may efficiently absorb the main pulse laser beam.

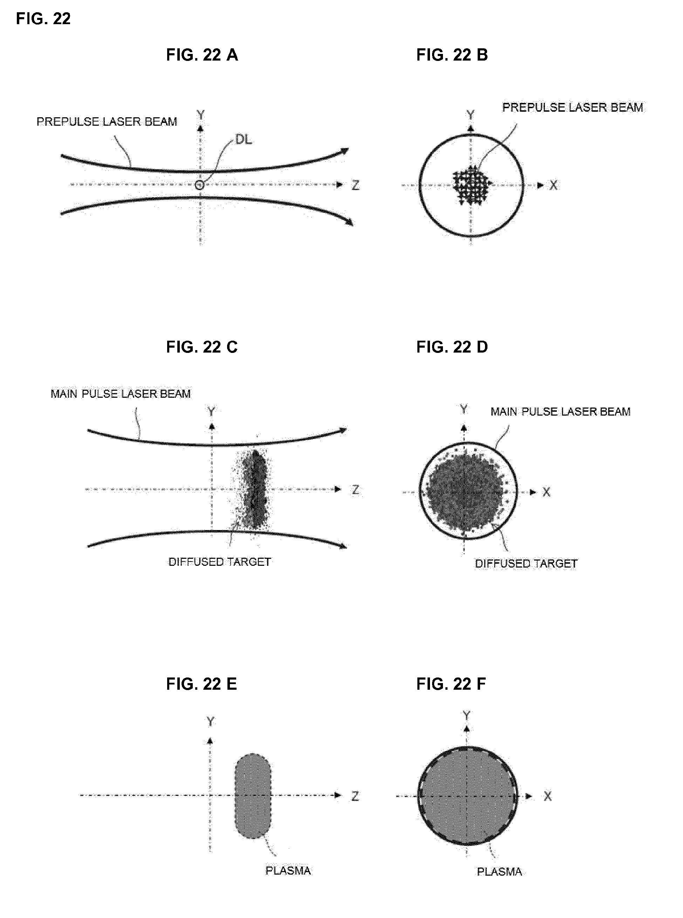

FIGS. 22A through 22F are schematic diagrams illustrating a state in which the droplet is irradiated with a spatially random linearly polarized prepulse laser beam and the diffused droplet is irradiated with the main pulse laser beam in the seventh embodiment. FIGS. 22A and 22B illustrate the state in which the droplet is irradiated with the spatially random linearly polarized prepulse laser beam. FIGS. 22C and 22D illustrate the state in which the droplet that is diffused by the irradiation with the prepulse laser beam is irradiated with the main pulse laser beam. FIGS. 22E and 22F illustrate the state in which the plasma is generated by the irradiation with the main pulse laser beam.

In the prepulse laser beam illustrated in FIG. 22B, a distribution of the linearly polarized beam that is perpendicular along the cross section (XY plane) perpendicular to the beam axis is spatially random. In the spatially random linearly polarized beam, a ratio of the beam intensity of the polarization component in the X direction and the polarization component in the Y direction becomes substantially 1:1. A case will be considered in which the droplet is irradiated with the spatially random linearly polarized prepulse laser beam. The spatially random linearly polarized beam is in a polarization state in which a large number of regions having linear polarization coexist, when the inside of the laser beam is viewed microscopically. When the droplet is irradiated with such a spatially random linearly polarized prepulse laser beam, a distribution of the absorptance of the prepulse laser beam on the droplet surface becomes approximately symmetrical with respect to the center axis of the droplet. As a result, the diffused state of the droplet becomes symmetrical with respect to the center axis of the droplet, and for example, the shape of the diffused target becomes a disk shape. Hence, the diffused target may efficiently absorb the main pulse laser beam.

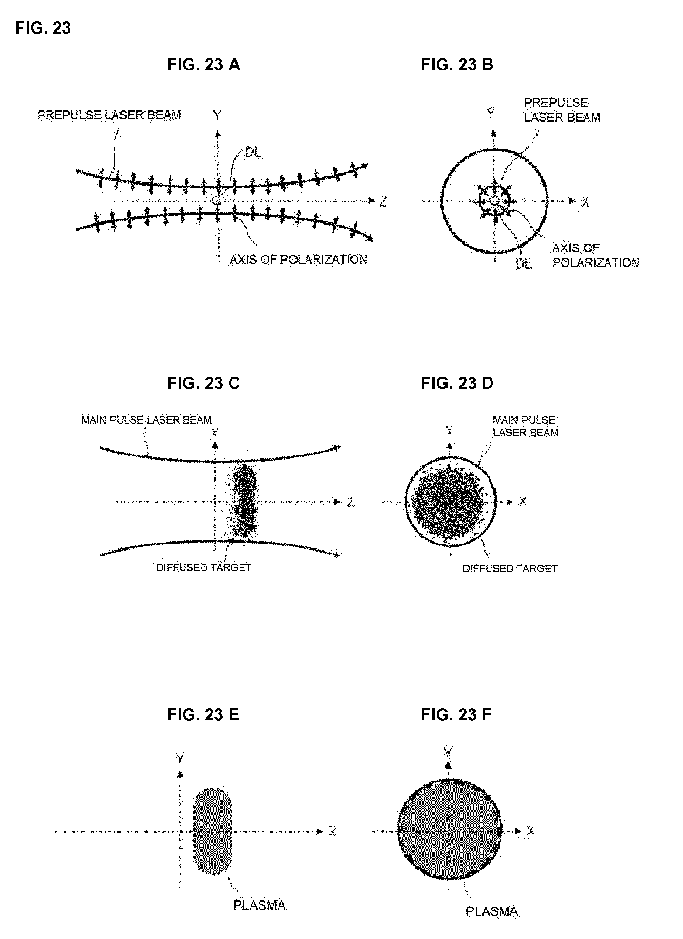

FIGS. 23A through 23F are schematic diagrams illustrating a state in which the droplet is irradiated with a radially polarized prepulse laser beam and the diffused droplet is irradiated with the main pulse laser beam in the seventh embodiment. FIGS. 23A and 23B illustrate the state in which the droplet is irradiated with the radially polarized prepulse laser beam. FIGS. 23C and 23D illustrate the state in which the droplet that is diffused by the irradiation with the prepulse laser beam is irradiated with the main pulse laser beam. FIGS. 23E and 23F illustrate the state in which the plasma is generated by the irradiation with the main pulse laser beam.

In the radially polarized beam, the polarization orientation in the cross section (XY plane) perpendicular to the beam axis is radial and is symmetrical with respect to the beam axis. When the droplet is irradiated with such a radially polarized prepulse laser beam, a distribution of the absorptance of the prepulse laser beam on the droplet surface becomes symmetrical with respect to the beam axis of the prepulse laser beam. In this state, the beam axis of the prepulse laser beam preferably coincides with the center axis of the droplet. As a result, the diffused state of the droplet becomes symmetrical with respect to the beam axis of the prepulse laser beam, and for example, the shape of the diffused target becomes a disk shape. Hence, the diffused target may efficiently absorb the main pulse laser beam.

When the spot size of the prepulse laser beam is greater than or equal to the diameter (for example, 40 $\mu$m) of the droplet, the radially polarized prepulse laser beam becomes incident on the entire light source side hemispherical surface of the droplet DL with the P-polarization. Accordingly, the absorptance of the prepulse laser beam may be improved, and the energy of the prepulse laser beam required to generate the diffused target in a suitable state may be low.

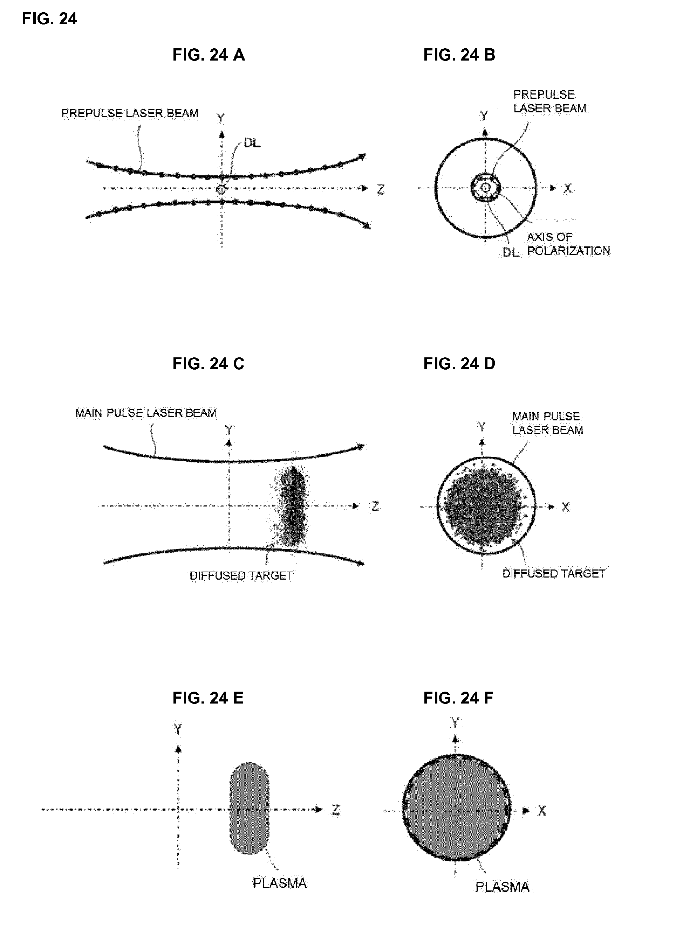

FIGS. 24A through 24F are schematic diagrams illustrating a state in which the droplet is irradiated with an azimuthally polarized prepulse laser beam and the diffused droplet is irradiated with the main pulse laser beam in the seventh embodiment. FIGS. 24A and 24B illustrate the state in which the droplet is irradiated with the azimuthally polarized prepulse laser beam. FIGS. 24C and 24D illustrate the state in which the droplet that is diffused by the irradiation with the prepulse laser beam is irradiated with the main pulse laser beam. FIGS. 24E and 24F illustrate the state in which the plasma is generated by the irradiation with the main pulse laser beam.

In the azimuthally polarized beam, the polarization orientation in the cross section (XY plane) perpendicular to the beam axis faces a tangential direction at each point, and is symmetrical with respect to the beam axis (Z-axis). When the droplet is irradiated with such an azimuthally polarized prepulse laser beam, a distribution of the absorptance of the prepulse laser beam on the droplet surface becomes symmetrical with respect to the beam axis of the prepulse laser beam. In this state, the beam axis of the prepulse laser beam preferably coincides with the center axis of the droplet. As a result, the diffused state of the droplet becomes symmetrical with respect to the beam axis of the prepulse laser beam, and for example, the shape of the diffused target becomes a disk shape. Hence, the diffused target may efficiently absorb the main pulse laser beam.

The seventh embodiment is described for a case in which the distribution of the absorptance of the prepulse laser beam on the droplet surface is symmetrical with respect to the center axis of the droplet or the beam axis of the prepulse laser beam, by changing the polarization state of the prepulse laser beam. However, the present disclosure is not limited to such a case. The distribution of the absorptance of the prepulse laser beam on the droplet surface may not be perfectly symmetrical with respect to the beam axis, and may be symmetrical to a certain extent. Accordingly, the polarization state of the prepulse laser beam may, for example, be an elliptical polarization state.

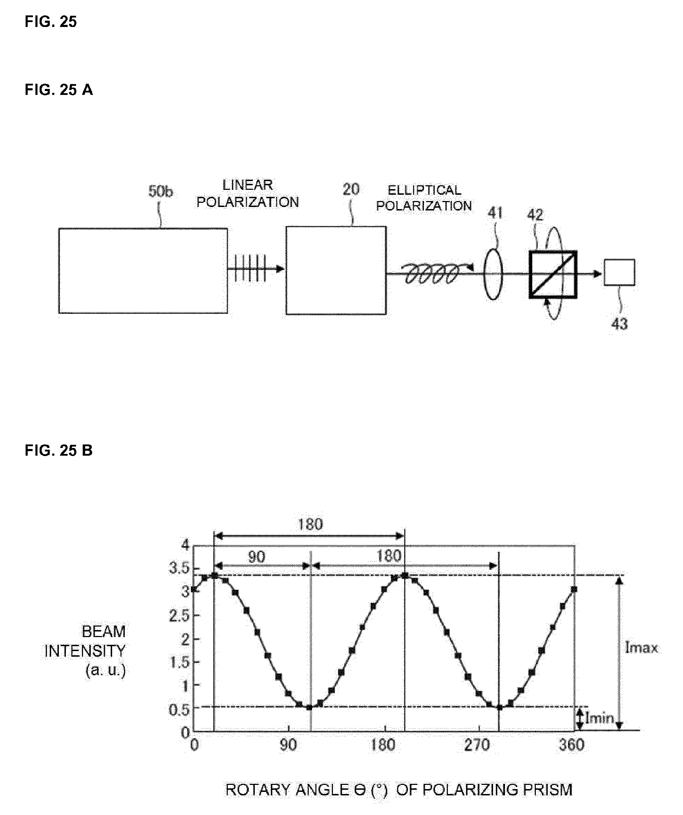

FIGS. 25A and 25B are diagrams for discussing an example of a degree of linear polarization measuring method to measure a ratio of linear polarization. FIG. 25A illustrates a measuring apparatus, which includes a polarizing prism and a beam intensity detector, to measure the degree of linear polarization. FIG. 25B illustrates an example of a relationship between a rotary angle of the polarizing prism and a detection result of the beam intensity detector.

As illustrated in FIG. 25A, suppose that the linearly polarized prepulse laser beam output from the fiber laser 50b is transformed into an elliptically polarized beam by the polarizer 20. The elliptically polarized beam is focused by a focusing optical system 41, and becomes incident on a polarizing prism 42. Beam intensity of the beam emitted from the polarizing prism 42 is detected by a beam intensity detector 43. The polarizing prism 42 may be formed by bonding two birefringent crystals, such as calcite. The polarizing prism 42 is used to obtain beam having a predetermined polarization direction depending on the direction of the prism bonding surface, from the incident beam, as emitted beam thereof. By rotating the polarizing prism 42 about the beam axis of the prepulse laser beam, the polarizing prism 42 transmits a beam having a polarization direction depending on the rotary angle. In the following description, it is assumed that the polarizing prism 42 is an ideal polarizing prism having a sufficiently high extinction ratio.

As illustrated in FIG. 25B, every time the polarizing prism 42 is rotated by 180°, the beam intensity of the beam emitted from the polarizing prism 42 changes periodically. The degree of linear polarization P may be obtained from a maximum value Imax and a minimum value Imin of the beam intensity, as represented in the following formula (6).

$$P = (Imax-Imin)/(Imax+Imin) \times 100 \ (\%)$$
$$--- Formula \ (6)$$

In a symmetrical polarization state (circular polarization, spatially random linear polarization, radial polarization, azimuthal polarization) with respect to the beam axis, the degree of linear polarization P measured by FIG. 25A becomes approximately 0%. On the other hand, in the case of the linear polarization, the degree of linear polarization P becomes approximately 100%. However, the diffused target may be formed to a shape close to a desired shape (for example, a disk shape) when a polarization component ratio R falls within the following ranges. Hence, the absorptance of the main pulse laser beam may be improved compared to the case in which the droplet is irradiated with the linearly polarized prepulse laser beam.

$$0\% \leq P < 30\% \text{ (Preferable Range)}$$

$$0\% \leq P < 20\% \text{ (More Preferable Range)}$$

$$0\% \leq P < 10\% \text{ (Most Preferable Range)}$$

These ranges may be corrected by taking into consideration the extinction ratio of the polarizing prism 42 that is actually used.

<10-3. Example of Polarizer>

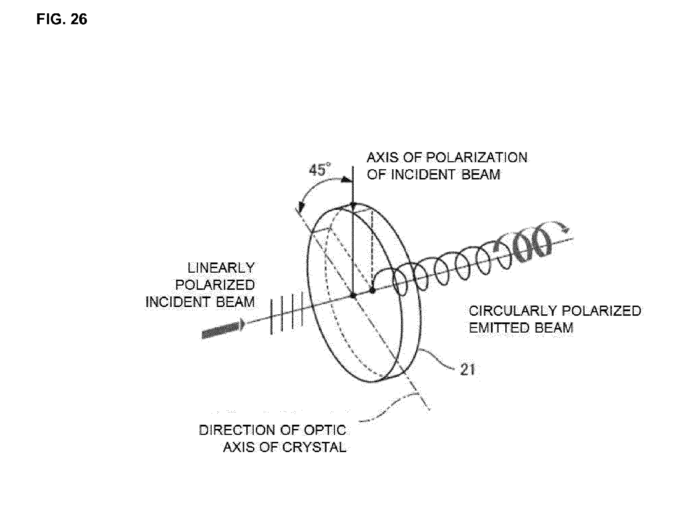

FIG. 26 is a perspective view illustrating a first example of the polarizer in the seventh embodiment. In FIG. 26, a quarter-wave plate 21 that transforms the linear polarization into the circular polarization is used as the polarizer.
A transmission quarter-wave plate 21 may be a birefringent crystal that provides a phase difference of n/2 between a polarization component parallel to an optic axis of the crystal and a polarization component perpendicular to the optic axis of the crystal while transmitting each of the two polarization components of the incident beam. As illustrated in FIG. 26, in a case in which the polarization direction of the linearly polarized incident beam that is perpendicularly incident on an incidence surface of the quarter-wave plate 21 is inclined by +45° with respect to the optic axis of the quarter-wave plate 21, the beam emitted from the quarter-wave plate 21 becomes a circularly polarized beam. In addition, in a case in which the polarization direction of the linearly polarized incident beam is inclined by -45° with respect to the optic axis of the quarter-wave plate 21, the beam emitted from the quarter-wave plate 21 becomes a circularly polarized beam having a reverse rotating direction. The present disclosure is not limited to the case using the transmission quarter-wave plate 21, and a reflection quarter-wave plate may be used.

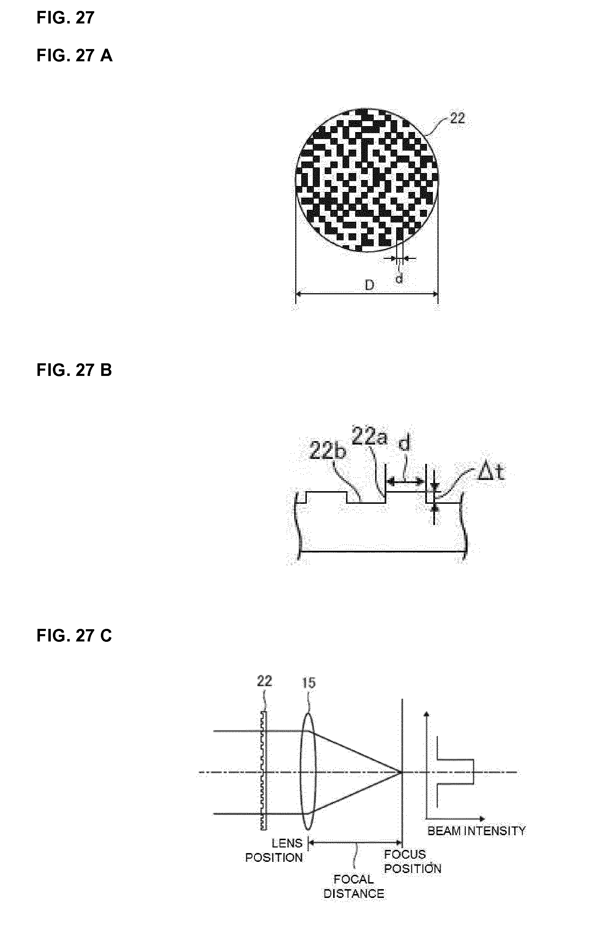

FIGS. 27A through 27C are diagrams illustrating a second example of the polarizer in the seventh embodiment. FIG. 27A illustrates a front view of the polarizer; FIG. 27B illustrates a part of a cross section along a radial direction of the polarizer on an enlarged scale; and FIG. 27C illustrates a state of use of the polarizer. In FIGS. 27A through 27C, a random phase plate 22 that transforms the linear polarization into the spatially random linear polarization is used as the polarizer.
The transmission random phase plate 22 has a configuration in which a micro-square region having a length d on each side is formed by a concave part or a convex part, for example, on an incidence surface or an emission surface of the transmission optical element having a diameter D, and such micro-square regions are arranged at random. The random phase plate 22 splits the incident beam having the diameter D into micro-square beams each having a length d on each side. In addition, the random phase plate 22 provides a phase difference of n between a micro-beam transmitted through a convex part 22a and a micro-beam transmitted through a concave part 22b. The phase difference of n may be obtained by setting a step difference $\Delta t$ between the convex part 22a and the concave part 22b according to the following formula (7), where $\lambda$ denotes the wavelength of the incident beam and $n_1$ denotes the refractive index of the random phase plate 22.

$$\Delta t = \lambda/2(n_1 - 1) \qquad \text{--- Formula (7)}$$

As illustrated in FIG. 27C, the transmission random phase plate 22 is arranged between a prepulse laser apparatus and a focusing optical system 15, for example. The linearly polarized laser beam is incident to the random phase plate 22, and the laser beam transmitted through the random phase plate 22 is transformed into the spatially random linearly polarized beam in which the polarization orientations are mutually perpendicular. The laser beams having the mutually perpendicular polarization orientations do not interfere with each other. For this reason, the beam intensity distribution on the beam cross section at a focus position of the focusing optical system 15 is not a Gaussian distribution, and is closer to a top hat distribution. By irradiating the droplet with such a prepulse laser beam, the diffused state of the droplet becomes symmetrical with respect to the center axis of the droplet. For this reason, the shape of the diffused target becomes a disk shape, for example, and the diffused target may efficiently absorb the main pulse laser beam.

The present disclosure is not limited to the case using the transmission random phase plate 22, and a reflection random phase plate may be used. In addition, although the random phase plate 22 described above includes the convex part 22a and the concave part 22b having the square planar shape, the planar shape of the convex part 22a and the concave part 22b may be hexagonal, triangular, or other polygonal shapes.

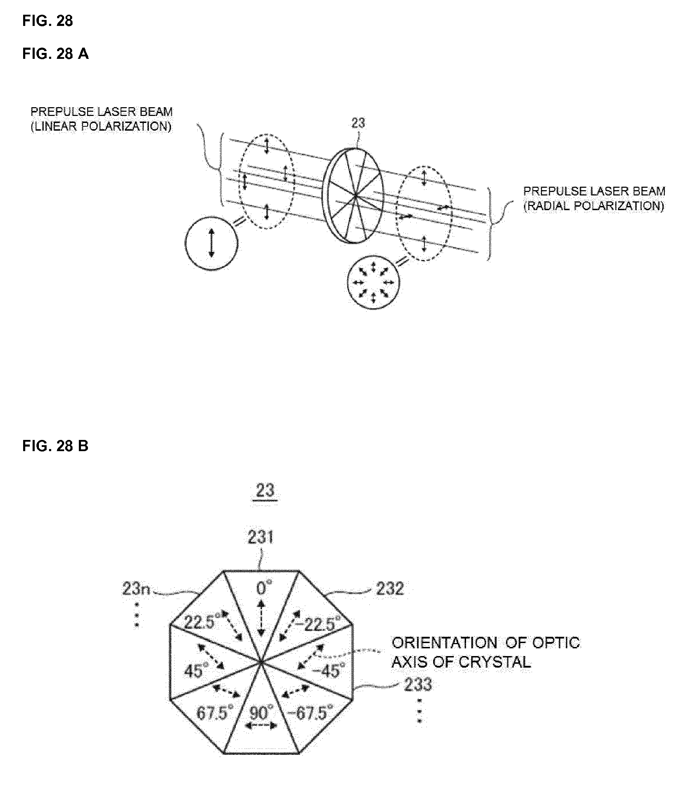

FIGS. 28A and 28B are diagrams illustrating a third example of the polarizer in the seventh embodiment. FIG. 28A illustrates a perspective view of the polarizer, and FIG. 28B illustrates a front view of the polarizer. In FIGS. 28A and 28B, a n-segment wave plate 23 that transforms the linearly polarized beam into the radially polarized beam is used as the polarizer.

The n-segment wave plate 23 is a transmission optical element having triangular n half-wave plates 231, 232, ..., 23n arranged symmetrically with respect to the center axis of the laser beam. Each of the half-wave plates 231, 232, ..., 23n may be a birefringent crystal that provides a phase difference of n between a polarization component parallel to an optic axis of the crystal and a polarization component perpendicular to the optic axis of the crystal while transmitting each of the two polarization components of the incident beam. When the polarization direction of the linearly polarized incident beam perpendicularly incident on the incidence surface of such a half-wave plate is inclined by an angle θ with respect to the optic axis of the crystal of the half-wave plate, the emitted beam becomes linearly polarized beam that is further inclined by the angle θ with respect to the optic axis of the crystal of the half-wave plate. In other words, the polarization direction of the emitted beam is inclined by an angle 2θ from the polarization direction of the incident beam.

For example, the half-wave plate 231 and the half-wave plate 233 are arranged so that the optic axes of the crystals differ by 45°. Hence, the polarization directions of the linearly polarized beam transmitted through the half-wave plate 231 and the linearly polarized beam transmitted through the half-wave plate 233 differ by 90°. In this manner, the polarization direction of the incident beam is transformed depending on the angle formed by the optic axis of each half-wave plate and the polarization direction of the incident beam. Accordingly, the polarization direction of the laser beam transmitted through each half-wave plate is transformed into a predetermined polarization direction. As a result, the n-segment wave plate 23 may transform the linearly polarized beam into the radially polarized beam. In addition, by changing the arrangement of the n-segment wave plate 23, the linearly polarized beam may be transformed into the azimuthally polarized beam.

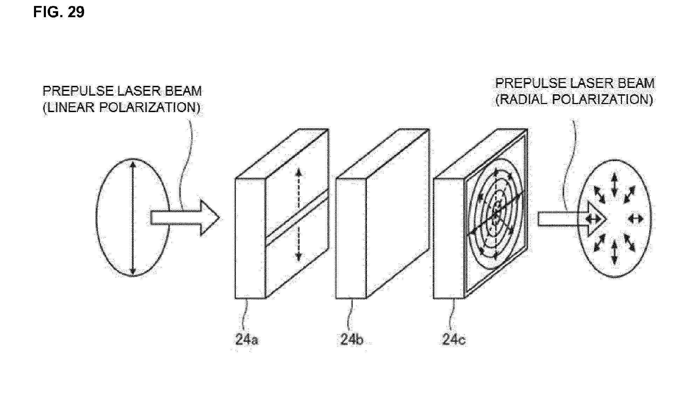

FIG. 29 is a diagram illustrating a fourth example of the polarizer in the seventh embodiment. In FIG. 29, a phase correction plate 24a, a polarization rotating plate 24b, and a theta-cell 24c are used as the polarizer that transforms the linearly polarized beam into the radially polarized beam.

The theta-cell 24c may be an optical element filled with a twisted nematic (TN) liquid crystal, and each liquid crystal molecule is arranged so that the liquid crystal molecules are aligned in a twisted manner from the incidence side towards the emission side of the beam. The linearly polarized incident beam incident on the theta-cell 24c undergoes an optical rotation according to the twisted alignment of the liquid crystal molecules, and linearly polarized beam having a polarization direction inclined with respect to the polarization direction of the incident beam is emitted from the theta-cell 24c. Accordingly, by making the twist angle of the aligned liquid crystal molecules in the theta-cell 24c different depending on the azimuthal direction, the theta-cell 24c may transform the linearly polarized incident beam into a radially polarized emitted beam.

However, when an attempt is made to transform the linear polarization into the radial polarization using only the theta-cell 24c, the beam intensity may decrease in a vicinity of a boundary between an upper half and a lower half of the emitted beam that is emitted from the theta-cell 24c. Hence, the phase of the upper half of the incident beam is shifted by n in advance by the phase correction plate 24a, and the phase of the lower half of the incident beam is not shifted, when inputting the incident beam to the theta-cell 24c.

In FIG. 29, dotted arrows illustrated on the emission surface of the phase correction plate 24a indicate that the phases of the beam are opposite between the upper half and the lower half of the phase correction plate 24a. The upper half of the phase correction plate 24a may be a TN liquid crystal having the alignment of the liquid crystal molecules twisted by 180° from the incidence side toward the emission side of the beam, for example.

By inputting to the theta-cell 24c the linearly polarized beam having opposite phases between the upper half and the lower half of the phase correction plate 24a, a beam having the same phase is emitted from the vicinity of the boundary between the emitted beam emitted from the upper half and the emitted beam emitted from the lower half of the theta-cell 24c. Hence, the decrease in the beam intensity in the vicinity of the boundary between the upper half and the lower half of the emitted beam emitted from the theta-cell 24c may be suppressed.

The polarization rotating plate 24b may be an optical element that rotates the polarization direction of the linearly polarized incident beam by 90° before outputting the incident beam. When the polarization direction of the incident beam is rotated by 90° before inputting the incident beam to the theta-cell 24c, the theta-cell 24c may transform the linear polarization into the azimuthal polarization. The polarization rotating plate 24b may be a TN liquid crystal having the alignment of the liquid crystal molecules twisted by 90° from the incidence side toward the emission side of the beam, for example. In this case, the switching between the radial polarization and the azimuthal polarization may be made by controlling a DC voltage applied to the polarization rotating plate 24b, and switching the alignment of the liquid crystal molecules between a twisted state and a non-twisted state.

Accordingly, the polarization state may be changed freely by using the phase correction plate 24a, the polarization rotating plate 24b, and the theta-cell 24c. In addition, as described above in conjunction with FIGS. 26 through 28B, when changing the polarization direction using the wave plate (phase plate), the wavelength of the beam whose polarization direction is changed differs depending on the thickness of the wave plate (phase plate). On the other hand, as described above in conjunction with FIG. 29, when the theta-cell 24c is used, the polarization direction of incident beams having a wide range of wavelength bands may be changed. Accordingly, when the theta-cell 24c is used, the polarization direction may be changed even in a case in which the bandwidth of the prepulse laser beam is wide.

<11. Eighth Embodiment>

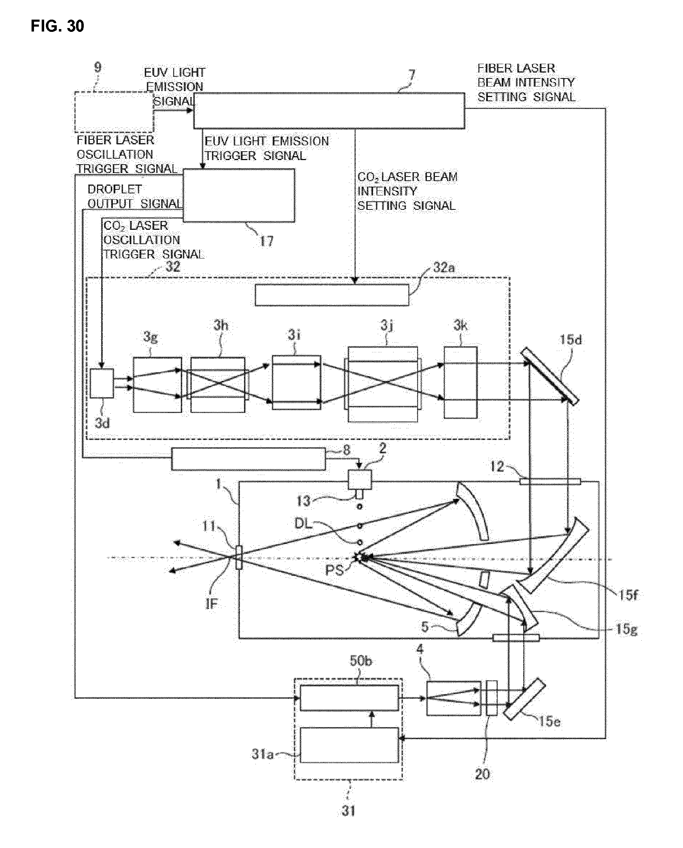

FIG. 30 is a schematic diagram of an EUV light source apparatus in an eighth embodiment. The eighth embodiment has a configuration in which the polarization state of the prepulse laser beam output from the fiber laser system 31 is changed by the polarizer 20, and this prepulse laser beam is supplied into the chamber 1 via a route different from that of the main pulse laser beam. The configurations of the fiber laser system 31 and the polarizer 20 may be the same as those described above with reference to the seventh embodiment. Other features may be the same as those of the second embodiment.

<12. Ninth Embodiment>

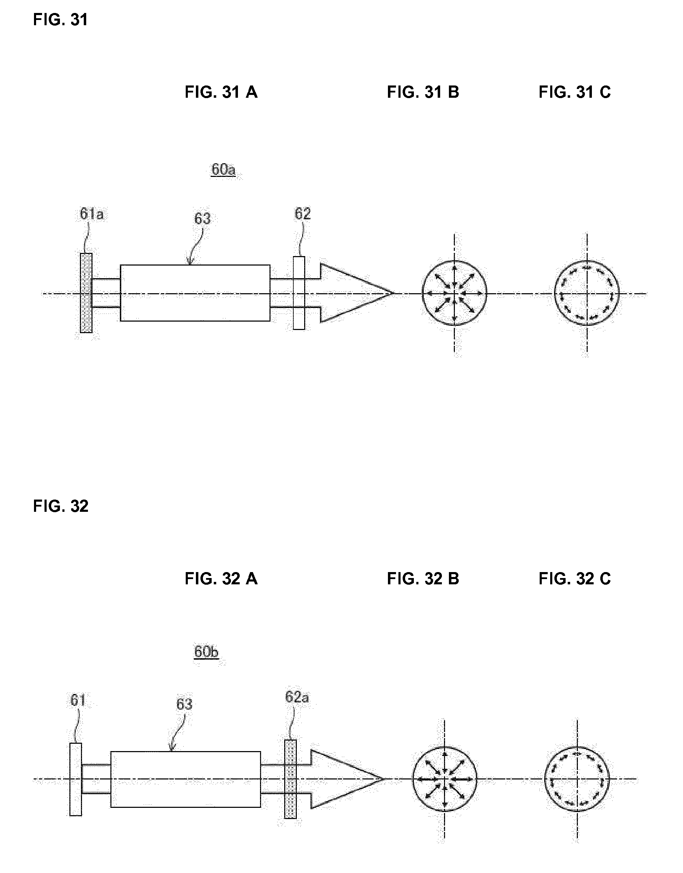

FIGS. 31A through 31C are schematic diagrams illustrating an example of the configuration of a laser apparatus that generates the prepulse laser beam in an EUV light source apparatus in a ninth embodiment. A laser apparatus 60a in the ninth embodiment is provided outside the chamber, as a driver laser to generate the prepulse laser beam that diffuses the droplet in the first through fourth embodiments described above.

As illustrated in FIG. 31A, the laser apparatus 60a includes a laser resonator including a reflection polarizer 61a and a front mirror 62. A laser medium 63 is arranged within the laser resonator. A laser beam is generated from the laser medium 63 by stimulated emission in response to excitation light output from an excitation light source that is not illustrated. The laser beam of the stimulated emission is amplified by the laser medium 63 while reciprocating between the polarizer 61a and the front mirror 62, to oscillate the laser beam from the laser apparatus 60a.

The polarizer 61a has a function of reflecting a beam having a predetermined polarization direction with high reflectance depending on an incidence position of the polarizer 61a. The radially polarized beam illustrated in FIG. 31B, or the azimuthally polarized beam illustrated in FIG. 31C is amplified in the laser resonator, depending on the reflection characteristics of the polarizer 61a. A portion of the amplified beam is transmitted through the front mirror 62, and is output as the prepulse laser beam.

According to the ninth embodiment, the polarizer is used in a part of the resonator of the driver laser. For this reason, it is unnecessary to arrange a polarizer in the optical path between the driver laser and the plasma generation site (PS) as is required in the case of the seventh embodiment.

FIGS. 32A through 32C are schematic diagrams illustrating an example of the configuration of the laser apparatus that generates the prepulse laser beam in an EUV light source apparatus in a modification of the ninth embodiment. A laser apparatus 60b in this modification includes a laser resonator including a rear mirror 61 and a reflection polarizer 62a. The radially polarized beam illustrated in FIG. 32B, or the azimuthally polarized beam illustrated in FIG. 32C is amplified in the laser resonator, depending on the reflection characteristics of the polarizer 62a. A portion of the amplified beam is transmitted through the polarizer 62a, and is output as the prepulse laser beam.

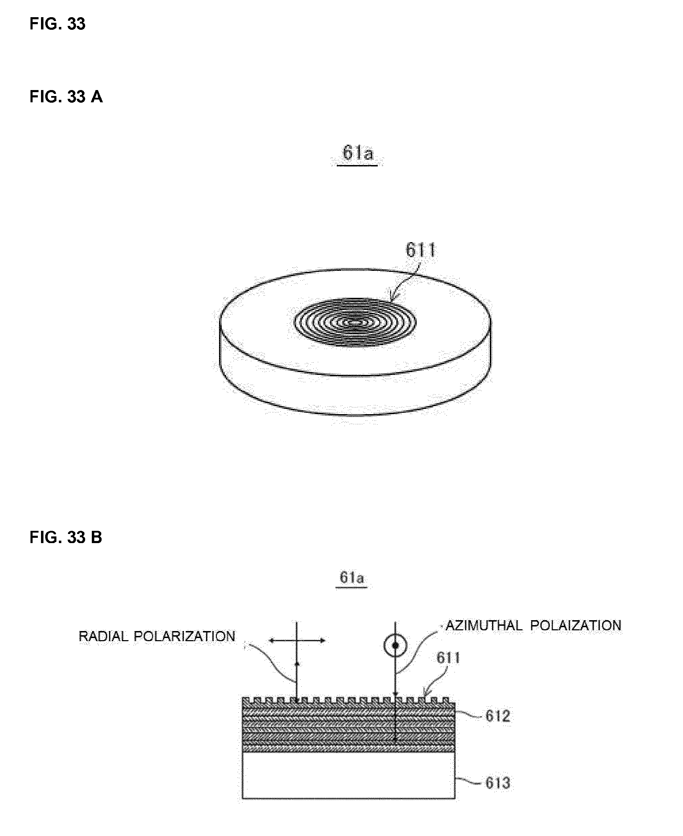

FIGS. 33A and 33B are diagrams illustrating an example of the polarizer in the ninth embodiment. FIG. 33A illustrates a perspective view of the polarizer, and FIG. 33B illustrates a part of a cross section along a radial direction of a diffraction grating part of the polarizer on an enlarged scale. As illustrated in FIG. 33A, the reflection polarizer 61a may be a mirror having a concentric circular diffraction grating 611 formed on a reflection surface thereof. In addition, as illustrated in FIG. 33B, in the polarizer 61a, a multi-layer 612 may be formed on a glass substrate 613, and the diffraction grating 611 may be formed on a surface of the multi-layer 612.

When the azimuthally polarized beam (having a polarization direction approximately parallel to each groove direction of the diffraction grating 611) is incident on the polarizer 61a described above, the azimuthally polarized beam is transmitted through the diffraction grating 611 and propagates to the multi-layer 612. On the other hand, when the radially polarized beam (having the polarization direction approximately perpendicular to each groove direction of the diffraction grating 611) is incident on the polarizer 61a, the radially polarized beam is not transmitted but is reflected by the diffraction grating 611. In the ninth embodiment (refer to FIGS. 31A through 31C), this polarizer 61a is used in the laser resonator in order to realize the oscillation of the laser beam with the radial polarization.

When the grooves of the diffraction grating 611 are formed radially, the polarizer 61a may be formed to reflect the azimuthally polarized beam with high reflectance. In this case, the oscillation of the laser beam with the azimuthal polarization may be realized. In addition, by forming the diffraction grating 611 in the polarizer 62a of the modification of the ninth embodiment (refer to FIGS. 32A through 32C), the oscillation with the radial polarization or the azimuthal polarization becomes possible.

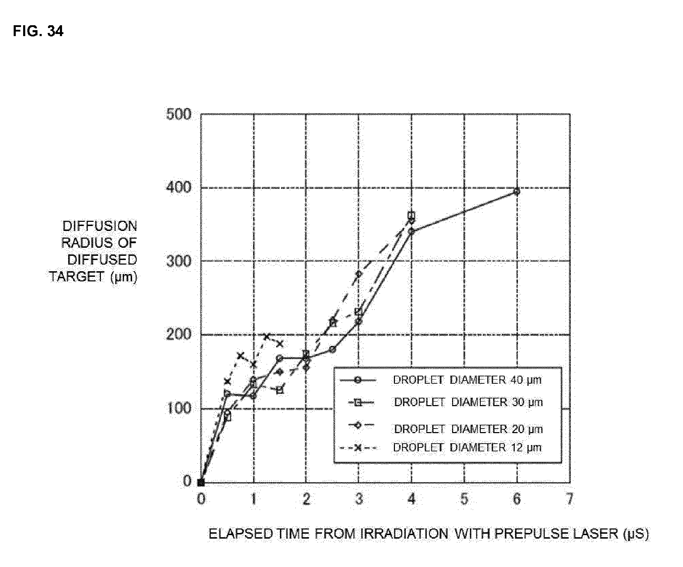

The present inventors discovered the possibility of reducing the variation in the energy of the EUV light regardless of the droplet diameter, by irradiating the droplet with the prepulse laser beam and irradiating the diffused target with the main pulse laser beam within a predetermined time from the prepulse laser beam irradiation. FIG. 34 is a diagram illustrating results of an experiment to generate the diffused target in the EUV light source apparatus in the eight embodiment. The prepulse laser beam is formed to a circularly polarized beam by a polarizer. In FIG. 34, the abscissa indicates an elapsed time from a time when the droplet is irradiated with the prepulse laser beam, and the ordinate indicates a diffusion radius of the diffused target that is generated when the droplet is irradiated with the prepulse laser beam. The diffusion radius refers to a radius of a space in which the existing particles have sizes greater than or equal to 6 $\mu$m in diameter. In FIG. 34, the lines are plots of the change over time in the diffused target radius from a time when the droplet is irradiated with the prepulse laser beam, for cases in which the droplet diameter is 12 $\mu$m, 20 $\mu$m, 30 $\mu$m, and 40 $\mu$m, respectively. As may be observed from FIG. 34, the dependency of the diffusion radius of the diffused target on the droplet diameter is low. In addition, during a time between 0.3 $\mu$S to 3 $\mu$S from the time when the droplet is irradiated with the prepulse laser beam, the change over time in the diffusion radius is relatively gradual. In this time band, it may be conjectured that the variation in the diffusion radius is small among the droplets. Accordingly, when the diffused target is irradiated with the main pulse laser beam during this time band, it may be expected that the variation of the energy of the EUV light that is generated is small among the pulses. By irradiating the diffused target with the main pulse laser beam within 0.3 $\mu$S to 3 $\mu$S from the time when the droplet is irradiated with the prepulse laser beam, there is a possibility of reducing the variation in the energy of the EUV light.

In the description given above, the driver laser 3 (FIG. 1) may correspond to a laser beam generating system to output a prepulse laser beam to strike a droplet, and a main pulse laser beam to strike a diffused target. The YAG pulse laser apparatus 3a (FIGS. 9 through 11) and the fiber laser system 31 (FIGS. 17 and 30) may respectively correspond to a first pulse laser apparatus to generate the prepulse laser beam. The $CO_2$ pulse laser apparatus 3b (FIGS. 9 through 11) and the $CO_2$ pulse laser system 32 (FIGS. 17 and 30) may respectively correspond to a second pulse laser apparatus to generate a main pulse laser beam. In addition, the EUV light source controller 7 (FIG. 1) may correspond to a laser controller to control beam intensity of the prepulse laser beam, beam intensity of the main pulse laser beam, and generation timings thereof.

## Claims

1. An extreme ultraviolet light generating apparatus, comprising:

   a laser beam generating system;
   a laser control system configured to control at least one of a beam intensity and an output timing of at least one laser beam output from the laser beam generating system;
   a chamber provided with at least one inlet to guide the at least one laser beam output from the laser beam generating system into the chamber; and
   a target supplying part, provided in the chamber, and configured to supply a target material to a predetermined region inside the chamber.

2. The extreme ultraviolet light generating apparatus as claimed in claim 1, wherein the target material is supplied to the predetermined region in the form of a droplet.

3. The extreme ultraviolet light generating apparatus as claimed in claim 1, wherein
   the laser beam generating system includes a first laser apparatus, and
   the first laser apparatus is configured to output a first prepulse laser beam with which the target material is irradiated inside the chamber.

4. The extreme ultraviolet light generating apparatus as claimed in claim 3, wherein the first laser apparatus includes a YAG laser apparatus.

5. The extreme ultraviolet light generating apparatus as claimed in claim 3, wherein the first laser apparatus includes a fiber laser apparatus.

6. The extreme ultraviolet light generating apparatus as claimed in claim 3, wherein the first laser apparatus includes a titanium-sapphire laser apparatus.

7. The extreme ultraviolet light generating apparatus as claimed in claim 3, wherein
a polarizer is provided in an optical path of the first prepulse laser beam, and
a polarization state of the first prepulse laser beam transmitted through the polarizer is changed to a polarization state in which a maximum value of a value R defined by

$$\texttt{R = |I}_1\texttt{ - I}_2\texttt{|/|I}_1\texttt{ + I}_2\texttt{| × 100 (\%)}$$

is 0% or greater and less than 30%, where $I_1$ and $I_2$ respectively denote beam intensities of mutually perpendicular first and second polarization components included in the first prepulse laser beam.

8. The extreme ultraviolet light generating apparatus as claimed in claim 7, wherein the polarization state of the first prepulse laser beam transmitted through the polarizer is changed to a circular polarization.

9. The extreme ultraviolet light generating apparatus as claimed in claim 7, wherein the polarization state of the first prepulse laser beam transmitted through the polarizer is changed to a radial polarization.

10. The extreme ultraviolet light generating apparatus as claimed in claim 7, wherein the polarization state of the first prepulse laser beam transmitted through the polarizer is changed to a polarization state that is symmetrical with respect to a beam axis of the first prepulse laser beam.

11. The extreme ultraviolet light generating apparatus as claimed in claim 3, wherein
the laser beam generating system further includes a second laser apparatus, and
the second laser apparatus is configured to output a first main pulse laser beam with which the target material that is irradiated with the first prepulse beam is irradiated.

12. The extreme ultraviolet light generating apparatus as claimed in claim 11, wherein the second laser apparatus includes a $CO_2$ laser apparatus.

13. The extreme ultraviolet light generating apparatus as claimed in claim 11, wherein the first prepulse laser beam has a wavelength shorter than a wavelength of the first main pulse laser beam.

14. The extreme ultraviolet light generating apparatus as claimed in claim 11, wherein the laser control system controls an output timing of the first main pulse laser beam to a timing within a range of 0.3 μS to 3 μS from a time when the target material is irradiated with the first prepulse laser beam.

15. The extreme ultraviolet light generating apparatus as claimed in claim 14, wherein the target material irradiated with the first prepulse laser beam has a shape that is one of a disk shape and a dish shape.

16. The extreme ultraviolet light generating apparatus as claimed in claim 15, wherein the shape of the target material irradiated with the first prepulse laser beam has a length in a propagating direction of the first prepulse laser beam shorter than a length in a direction perpendicular to the propagating direction of the first prepulse laser beam.

17. The extreme ultraviolet light generating apparatus as claimed in claim 11, wherein the target material is irradiated with the first main pulse laser beam in a direction that is approximately identical to that of the first prepulse laser beam.

18. The extreme ultraviolet light generating apparatus as claimed in claim 17, wherein an area of a beam cross section of the first main pulse laser beam at a time when the target material is irradiated wit the first main pulse laser beam is greater than or equal to a maximum area of a cross section of the target material taken along a plane perpendicular to a propagating direction of the first main pulse laser beam.

19. The extreme ultraviolet light generating apparatus as claimed in claim 11, wherein
the target material is supplied to the predetermined region in the form of a droplet,
the droplet has a diameter of 12 μm or greater and 40 μm or less,
the laser control system controls a beam intensity of the first prepulse laser beam to $6.4 \times 10^9$ W/cm$^2$ or higher and

$3.2 \times 10^{10}$ W/cm$^2$ or less, and
the laser control system controls an output timing of the first main pulse laser beam to a timing within a range of 0.5 $\mu$S to 2 $\mu$S from a time when the droplet is irradiated with the first prepulse laser beam.

20. The extreme ultraviolet light generating apparatus as claimed in claim 19, wherein the target material irradiated with the first prepulse laser beam has a shape that is approximately symmetrical with respect to a beam axis of the first prepulse laser beam and is substantially ring-shaped.

21. The extreme ultraviolet light generating apparatus as claimed in claim 3, wherein
the laser beam generating system further includes a third laser apparatus, and
the third laser apparatus is configured to output a second prepulse laser beam with which the target material that is irradiated with the first prepulse laser beam is irradiated, and a second main pulse laser beam with which the target material that is irradiated with the second prepulse laser beam is irradiated.

22. The extreme ultraviolet light generating apparatus as claimed in claim 21, wherein the third laser apparatus includes a $CO_2$ laser apparatus.

23. The extreme ultraviolet light generating apparatus as claimed in claim 21, wherein the first prepulse laser beam has a wavelength shorter than a wavelength of the second prepulse laser beam.

24. The extreme ultraviolet light generating apparatus as claimed in claim 21, wherein the target material is irradiated with the second prepulse laser beam and the second main pulse laser beam in a direction approximately identical to that of the first prepulse laser beam.

25. The extreme ultraviolet light generating apparatus as claimed in claim 24, wherein an area of a beam cross section of the second main pulse laser beam at a time when the target material is irradiated with the second main pulse laser beam is greater than or equal to a maximum area of a cross section of the target material taken along a plane perpendicular to a propagating direction of the second main pulse laser beam.

26. A method to generate extreme ultraviolet light in an ultraviolet light generating apparatus including a laser beam generating system, a laser control system, a chamber, and a target supplying part, the method comprising:

supplying a target material into the chamber in a form of a droplet;
irradiating the droplet with a prepulse laser beam output from the laser beam generating system; and
after a predetermined time elapses from a time when the droplet is irradiated with the prepulse laser beam, irradiating the droplet irradiated with the prepulse laser beam with a main pulse laser beam output from the laser beam generating system.

27. The method as claimed in claim 26, wherein the predetermined time is within a range of 0.5 $\mu$S to 3 $\mu$S.

**FIG. 1**

OSCILLATION TRIGGER
DETECTION SIGNAL

EUV PULSE
ENERGY
DETECTION
SIGNAL

OSCILLATION
TRIGGER
SIGNAL

LASER BEAM
INTENSITY
SIGNAL

FIG. 2

LASER ABLATION REGION

SHOCK WAVE

PREPULSE LASER BEAM

DL

FIG. 3

FIG. 3A

MAIN PULSE LASER BEAM

Z

PREPULSE LASER
BEAM INTENSITY

**6.4 × 10⁸ W/cm²
(X1.0)**

FIG. 3B

MAIN PULSE LASER BEAM

Z

Dd    Dm

PREPULSE LASER
BEAM INTENSITY

**1.6 × 10⁹ W/cm²
(X2.5)**

FIG. 3C

MAIN PULSE LASER BEAM

Z

PREPULSE LASER
BEAM INTENSITY

**5.5x10⁹ W/cm²
(X8.6)**

FIG. 3D

Z

**FIG. 4 A**

MAIN PULSE
LASER BEAM

Z DIRECTION

TORUS DIFFUSED
TARGET

FIG. 4B

TORUS DIFFUSED TARGET

Dout

Dm

Y

Z X

MAIN PULSE LASER BEAM

**FIG. 5**

| FIG. 5 A | FIG. 5 B | FIG. 5 C | FIG. 5 D |
|----------|----------|----------|----------|

PREPULSE
LASER BEAM

**300** μ m

Y

X Z

TIME T AFTER
IRRADIATION WITH
PREPULSE

**0** μ s   **0.4** μ s   **0.8** μ s   **1.4** μ s

DROPLET DIAMETER
AFTER DIFFUSION   60 μ m

| | MAX/MIN 48.0/3.7 μ m | MAX/MIN 48.0/3.5 μ m | MAX/MIN 48.0/3.1 μ m |
|--|--|--|--|

| FIG. 5 E | FIG. 5 F | FIG. 5 G | FIG. 5 H |
|----------|----------|----------|----------|

Y

Z X

**FIG. 5 I**

⊚ IRRADIATION SPOT SIZE OF MAIN PULSE LASER

**200-300** μ m

FIG. 6

DROPLET DIAMETER = 60 μm

DELAY TIME T (μs)

FIG. 7

FIG. 7A          FIG. 7B          FIG. 7C          FIG. 7D

300 μm

PREPULSE
LASER BEAM

Y
↑
X ⊙→Z

| TIME T AFTER IRRADIATION WITH PREPULSE | 0 μs | 0.1 μs | 0.25 μs | 0.5 μs |
|---|---|---|---|---|
| DROPLET DIAMETER AFTER DIFFUSION | 10 μm | MAX/MIN 2.2/0.2 μm | MAX/MIN 1.1/0.2 μm | MAX/MIN 1.1/0.2 μm |

FIG. 7E          FIG. 7F          FIG. 7G          FIG. 7H

Y
↑
Z ⊙→X

FIG. 7I

IRRADIATION SPOT SIZE OF MAIN PULSE LASER

◎   200-300 μm

FIG. 8

DROPLET DIAMETER = 10 μm

FIG. 9

FIG. 10

FIG. 11

FIG. 12

Fig. 12A

FIRST PREPULSE
LASER BEAM

TIME T AFTER IRRADIATION
WITH PREPULSE

T=0

Fig. 12B

SECOND PREPULSE
LASER BEAM

T=t2

Fig. 12C

MAIN PULSE
LASER BEAM

T=tm

Fig. 12D

Fig. 12E

Fig. 12F

**FIG. 13**

DIRECTION OF
MAGNETIC FIELD

6a

19a

1

11

PS

IF

19b

6b

5    15b

6c    6d

**FIG. 14**

**FIG. 15**

**FIG. 16**

**FIG. 16 A**

EXAMPLES OF IRRADIATION CONDITIONS OF PREPULSE LASER BEAM

| | CASE 1 | CASE 2 | CASE 3 | CASE 4 |
|---|---|---|---|---|
| IRRADIATION PULSE ENERGY E (mJ) | 1.9 | 0.17 | 0.15 | 0.1 |
| PULSE DURATION T (ns) | 15 | 15 | 1 | 0.05 |
| IRRADIATION SPOT SIZE Dm (μm) | 100 | 30 | 30 | 30 |
| LASER BEAM INTENSITY W (W/cm$^2$) | $1.61 \times 10^9$ | $1.60 \times 10^9$ | $2.12 \times 10^{10}$ | $2.83 \times 10^{11}$ |

**FIG. 16 B**

EXAMPLES OF IRRADIATION CONDITIONS OF MAIN PULSE LASER

| | CASE 1 | CASE 2 | CASE 3 | CASE 4 |
|---|---|---|---|---|
| IRRADIATION PULSE ENERGY E (mJ) | 100 | 150 | 200 | 200 |
| PULSE DURATION T (ns) | 20 | 30 | 25 | 50 |
| IRRADIATION SPOT SIZE Dm (μm) | 250 | 250 | 300 | 200 |
| LASER BEAM INTENSITY W (W/cm$^2$) | $1.02 \times 10^{10}$ | $1.02 \times 10^{10}$ | $1.13 \times 10^{10}$ | $1.27 \times 10^{10}$ |

FIG. 17

**FIG. 18**

**FIG. 18 A**

Y DIRECTION

LASER ABLATION REGION

AXIS OF POLARIZATION

PREPULSE LASER BEAM

SHOCK WAVE

Z DIRECTION

DL

LASER ABLATION REGION

**FIG. 18 B**

Y DIRECTION

DIFFUSED TARGET

MAIN PULSE LASER BEAM

Z DIRECTION

**FIG. 19**

**FIG. 19 A**

Y DIRECTION

AXIS OF POLARIZATION

PREPULSE LASER BEAM

SHOCK WAVE

X DIRECTION

LASER ABLATION REGION

DL

**FIG. 19 B**

Y DIRECTION

DIFFUSED TARGET

X DIRECTION

MAIN PULSE LASER BEAM

FIG. 20

FIG. 21

FIG. 21 A

PREPULSE LASER BEAM

DL

LOCUS OF TIP OF
ELECTRIC FIELD
VECTOR

FIG. 21 B

PREPULSE LASER BEAM

DL

LOCUS OF TIP OF
ELECTRIC FIELD
VECTOR

FIG. 21 C

MAIN PULSE LASER BEAM

DIFFUSED TARGET

FIG. 21 D

MAIN PULSE LASER BEAM

DIFFUSED TARGET

FIG. 21 E

PLASMA

FIG. 21 F

PLASMA

**FIG. 22**

**FIG. 22 A**

PREPULSE LASER BEAM

DL

Y

Z

**FIG. 22 B**

PREPULSE LASER BEAM

Y

X

**FIG. 22 C**

MAIN PULSE LASER BEAM

Y

Z

DIFFUSED TARGET

**FIG. 22 D**

Y

MAIN PULSE LASER BEAM

X

DIFFUSED TARGET

**FIG. 22 E**

Y

Z

PLASMA

**FIG. 22 F**

Y

X

PLASMA

44

FIG. 23

FIG. 23 A

FIG. 23 B

PREPULSE LASER BEAM

PREPULSE
LASER BEAM

DL

AXIS OF POLARIZATION

AXIS OF
POLARIZATION

DL

FIG. 23 C

FIG. 23 D

MAIN PULSE LASER BEAM

MAIN PULSE
LASER BEAM

DIFFUSED TARGET

DIFFUSED TARGET

FIG. 23 E

FIG. 23 F

PLASMA

PLASMA

**FIG. 24**

**FIG. 24 A**

PREPULSE LASER BEAM

Y

DL

Z

**FIG. 24 B**

PREPULSE
LASER BEAM

Y

X

AXIS OF
POLARIZATION

DL

**FIG. 24 C**

MAIN PULSE LASER BEAM

Y

Z

DIFFUSED TARGET

**FIG. 24 D**

MAIN PULSE
LASER BEAM

Y

X

DIFFUSED TARGET

**FIG. 24 E**

Y

Z

PLASMA

**FIG. 24 F**

Y

X

PLASMA

**FIG. 25**

**FIG. 25 A**

**FIG. 25 B**

ROTARY ANGLE Θ (°) OF POLARIZING PRISM

**FIG. 26**

AXIS OF POLARIZATION
OF INCIDENT BEAM

45°

LINEARLY
POLARIZED
INCIDENT BEAM

CIRCULARLY POLARIZED
EMITTED BEAM

21

DIRECTION OF OPTIC
AXIS OF CRYSTAL

**FIG. 27**

**FIG. 27 A**

**FIG. 27 B**

**FIG. 27 C**

**FIG. 28**

**FIG. 28 A**

PREPULSE LASER BEAM
(LINEAR POLARIZATION)

23

PREPULSE LASER BEAM
(RADIAL POLARIZATION)

**FIG. 28 B**

23

231

23n

0°

232

22.5°

−22.5°

45°

−45°

ORIENTATION OF OPTIC
AXIS OF CRYSTAL

67.5°    90°    −67.5°

233

FIG. 29

PREPULSE LASER BEAM
(LINEAR POLARIZATION)

PREPULSE LASER BEAM
(RADIAL POLARIZATION)

24a    24b    24c

**FIG. 30**

**FIG. 31**

**FIG. 31 A**          **FIG. 31 B**          **FIG. 31 C**

60a

61a          63          62

**FIG. 32**

**FIG. 32 A**          **FIG. 32 B**          **FIG. 32 C**

60b

61          63          62a

**FIG. 33**

**FIG. 33 A**

61a

611

**FIG. 33 B**

61a

RADIAL POLARIZATION          AZIMUTHAL POLAIZATION

611

612

613

EP 2 538 759 A1

FIG. 34

ELAPSED TIME FROM IRRADIATION WITH PREPULSE LASER (μS)

55

## INTERNATIONAL SEARCH REPORT

| International application No. |
| --- |
| PCT/JP2011/052767 |

### A. CLASSIFICATION OF SUBJECT MATTER
*H05G2/00*(2006.01)i

According to International Patent Classification (IPC) or to both national classification and IPC

### B. FIELDS SEARCHED

Minimum documentation searched (classification system followed by classification symbols)
H05G2/00

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2010-3548 A (Komatsu Ltd.), 07 January 2010 (07.01.2010), (Family: none) | 1-5,11,12, 17,21,22,24, 26 |
| Y | | 6 |
| X | JP 2010-21543 A (Komatsu Ltd.), 28 January 2010 (28.01.2010), & US 2009/314967 A1 | 1-5,11,12, 17,21,22,24, 26 |
| Y | | 6 |
| X | JP 2009-260019 A (Komatsu Ltd.), 05 November 2009 (05.11.2009), & US 2009/261242 A1 | 1-5,11,12, 17,21,22,24, 26 |
| Y | | 6 |

| ☒ | Further documents are listed in the continuation of Box C. | ☐ | See patent family annex. |
| --- | --- | --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 10 May, 2011 (10.05.11) | 24 May, 2011 (24.05.11) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

### INTERNATIONAL SEARCH REPORT

| International application No. |
|---|
| PCT/JP2011/052767 |

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2007-33437 A  (Central Research Institute of Electric Power Industry), 08 February 2007 (08.02.2007), paragraph [0106] (Family: none) | 6 |
| Y | JP 2008-71547 A  (Central Research Institute of Electric Power Industry), 27 March 2008 (27.03.2008), paragraph [0056] (Family: none) | 6 |
| Y | JP 2008-277204 A  (Japan Atomic Energy Agency), 13 November 2008 (13.11.2008), paragraph [0019] (Family: none) | 6 |
| A | JP 2008-226462 A  (Komatsu Ltd.), 25 September 2008 (25.09.2008), (Family: none) | 1-6,11,12, 17,21,22,24, 26 |
| A | JP 2008-293738 A  (Komatsu Ltd.), 04 December 2008 (04.12.2008), paragraph [0012] (Family: none) | 1-6,11,12, 17,21,22,24, 26 |
| A | JP 2009-253032 A  (Komatsu Ltd.), 29 October 2009 (29.10.2009), & US 2009/250641 A1 | 1-6,11,12, 17,21,22,24, 26 |

Form PCT/ISA/210 (continuation of second sheet) (July 2009)

**INTERNATIONAL SEARCH REPORT**

| International application No. |
| --- |
| PCT/JP2011/052767 |

---

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

---

**Box No. III    Observations where unity of invention is lacking (Continuation of item 3 of first sheet)**

This International Searching Authority found multiple inventions in this international application, as follows:
    The matters set forth in claims 1 - 5, 11, 12, 17, 21, 22, 24, 26 are not novel, since the matters are disclosed in JP 2010-3548 A (Komatsu Ltd.), 7 January 2010 (07.01.2010), JP 2010-21543 A (Komatsu Ltd.), 28 January 2010 (28.01.2010), and JP 2009-260019 A (Komatsu Ltd.), 5 November 2009 (05.11.2009).

                                    (continued to extra sheet)

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:
    1 - 6, 11, 12, 17, 21, 22, 24, 26

**Remark on Protest**          ☐ The additional search fees were accompanied by the applicant's protest and, where applicable, the payment of a protest fee.

                  ☐ The additional search fees were accompanied by the applicant's protest but the applicable protest fee was not paid within the time limit specified in the invitation.

                  ☐ No protest accompanied the payment of additional search fees.

Form PCT/ISA/210 (continuation of first sheet (2)) (July 2009)

| **INTERNATIONAL SEARCH REPORT** | International application No. |
| --- | --- |
| | PCT/JP2011/052767 |

Continuation of Box No.III of continuation of first sheet(2)

   As a result, claims 1 - 6, 11, 12, 17, 21, 22, 24, 26 are classified into main invention, while claims 7 - 10, claim 13, claims 14 - 16, claim 18, claims 19, 20, claim 23, claim 25 and claim 27 are classified into different inventions, and therefore, it is considered that nine inventions are set forth in claims of the present application.
   Consequently, the inventions in claims 1 - 27 of the present application do not comply with unity of invention.

Form PCT/ISA/210 (extra sheet) (July 2009)